# EUROPEAN PATENT APPLICATION

(11) **EP 3 285 281 A1**
(43) Date of publication of application: **21.02.2018**
(21) Application number: 16780130.7
(22) Date of filing: 15.04.2016
(51) Int. Cl.: H01L 21/027, G03F 7/20, H01L 21/677

(54) **EXPOSURE SYSTEM**

(30) Priority: 17.04.2015 JP 2015085469; 01.09.2015 JP 2015171655
(71) Applicant: Nikon Corporation, Tokyo 108-6290 (JP)
(72) Inventor: SHIBAZAKI, Yuichi, Tokyo 108-6290 (JP)
(74) Representative: Hoffmann Eitle
(86) International application number: PCT/JP2016/062089
(87) International publication number: WO 2016/167339

(57) **Abstract**

An exposure system (1000) is equipped with: a first row of chambers (300₁ to 300₃) that are arranged to be adjacent to a C/D (9000) provided on a floor surface F on a +X side; a second row of chambers arranged on the -Y side facing the first row of chambers; and a first control rack (200) adjacent to the to the second row of chambers on a -X side and is arranged on the -Y side facing the C/D (9000) . Inside at least a part of the plurality of chambers, exposure chambers where exposure is performed are formed and the first control rack (200) distributes utilities supplied from the below the floor surface (F) to the first and the second rows of chambers.

## Description

### TECHNICAL FIELD

The present invention relates to exposure systems, and more particularly, to an exposure system that is partly connected to a substrate processing device which coats a sensitive agent on a target, and exposes the target on which the sensitive agent is coated with a charged particle beam.

### BACKGROUND ART

In exposure apparatuses used in a lithography process for manufacturing electronic devices (microdevices) such as semiconductor devices that use ultraviolet rays from the far ultraviolet region to the vacuum ultraviolet region as an exposure beam (hereinafter referred to as an ultraviolet ray exposure apparatus), in order to increase resolution, shortening exposure wavelength, optimizing illumination conditions, and applying a liquid immersion method to further increase numerical aperture of a projection optical system and the like have been performed.

In recent years, to form circuit patterns having a pitch finer than the resolution limit of the ultraviolet ray exposure apparatus, an electron beam exposure apparatus has been proposed that forms multiple circular spots smaller than the resolution limit of the ultraviolet ray exposure apparatus with an electron beam and relatively scans this circular spot of the electron beam and a wafer (for example, refer to PTL 1) .

Electron beam exposure apparatus is equipped with various control units to create a vacuum inside a chamber, which makes footprint larger than that of the ultraviolet ray exposure apparatus. Also, in the case of installing the electron beam exposure apparatus in a clean room of a semiconductor factory, since the exposure apparatus is to be arranged side by side with a coater/developer as in the ultraviolet ray exposure apparatus, efficient use of space in the clean room has to be taken into consideration.

### CITATION LIST

### PATENT LITERATURE

[PTL 1] U.S. Patent No. 7,173,263

### SUMMARY OF THE INVENTION

### MEANS FOR SOLVING THE PROBLEM

According to a first aspect of the present invention, there is provided an exposure system that exposes a target with a charged particle beam, comprising: a first chamber arranged adjacent to a substrate processing device which coats a sensitive agent on a target; a second chamber, with respect to the first chamber adjacent in a first direction with the substrate processing device, being arranged apart in a second direction intersecting the first direction; and a first control rack that is arranged adjacent or in close proximity to each of the second chamber and the substrate processing device, and is connected to an external utility supply source, wherein the first control rack distributes utilities supplied from the utility supply source to each of the first chamber and the second chamber.

According to a second aspect of the present invention, there is provided an exposure system that exposes a target on which a sensitive agent is coated with a charged particle beam, comprising: an exposure unit that has a stage device including a stage that can move holding the target and a charged particle beam irradiation device that performs exposure by irradiating the target with a charged particle beam, a vacuum chamber that houses at least a part of the exposure unit, and a mounting member provided in at least one of a side wall and a ceiling wall of the vacuum chamber and to which a supply member that supplies utilities supplied from an external utility supply source to the charged particle beam irradiation device is attached.

### BRIEF DESCRIPTION OF DRAWINGS

FIG. 1 shows a perspective view of an exposure system according to an embodiment, along with a resist coating/developing apparatus.
FIG. 2A shows a perspective view when viewed from a different angle from FIG. 1 of the exposure system according to the embodiment, along with the resist coating/developing apparatus, and FIG. 2B shows a perspective view when viewed from a different angle from FIGS. 1 and 2A of the exposure system according to the embodiment, along with the resist coating/developing apparatus.
FIG. 3 shows a planar view of the exposure system according to the embodiment, along with the resist coating/developing apparatus.
FIG. 4 shows a perspective view of part of the exposure system, excluding a first control rack, a frame, and a second control rack.
FIG. 5 is a view schematically showing a load lock chamber that a vacuum chamber is equipped with, along with an exposure unit housed inside an exposure chamber inside the vacuum chamber.
FIG. 6 shows a perspective view of the exposure unit.
FIG. 7 shows a perspective view of a state in which a wafer shuttle is attached to a coarse/fine movement stage mounted on a surface plate.
FIG. 8 shows a perspective view of the coarse/fine movement stage in FIG. 7 in which the wafer shuttle is detached from a fine movement stage.
FIG. 9 shows a view enlarging the coarse/fine movement stage mounted on the surface plate.
FIG. 10 shows a view of a state in which the fine movement stage and a magnetic shield member are removed from the coarse/fine movement stage shown in FIG. 8.
FIG. 11 is a view used to explain a structure of a self-weight canceling device.
FIGS. 12A and 12B are views (No. 1 and No. 2) used to explain a structure of a first measurement system.
FIG. 13A is a view used to explain a structure of each part inside a measurement chamber, and FIG. 13B is a view used to explain a movable range in a vertical direction of a measurement table in FIG. 13A.
FIG. 14 shows a block diagram of a structure of a control system of the exposure system.
FIG. 15 shows a block diagram of an input/output relation of a measurement controller that structures the control system in FIG. 14.
FIG. 16 shows a block diagram of an input/output relation of an exposure controller that structures the control system in FIG. 14.
FIG. 17A is a flowchart used to explain an example of a preparatory operation performed inside a measurement chamber 60, and 17B is a flowchart used to explain an unloading operation of a wafer that has been exposed inside measurement chamber 60.
FIG. 18 is a view (No. 1) used to explain an exchange operation of a wafer integral with a wafer shuttle.
FIG. 19 is a view (No. 2) used to explain the exchange operation of the wafer integral with the wafer shuttle.
FIG. 20 is a view (No. 3) used to explain the exchange operation of the wafer integral with the wafer shuttle.
FIG. 21 is a view (No. 4) used to explain the exchange operation of the wafer integral with the wafer shuttle.
FIG. 22 is a view (No. 5) used to explain the exchange operation of the wafer integral with the wafer shuttle.
FIG. 23 is a view (No. 6) used to explain the exchange operation of the wafer integral with the wafer shuttle.
FIG. 24 is a view (No. 7) used to explain the exchange operation of the wafer integral with the wafer shuttle.
FIG. 25 is a view (No. 8) used to explain the exchange operation of the wafer integral with the wafer shuttle.
FIG. 26 is a view (No. 9) used to explain the exchange operation of the wafer integral with the wafer shuttle.
FIG. 27 is a view (No. 10) used to explain the exchange operation of the wafer integral with the wafer shuttle.
FIG. 28 is a view used to explain an exposure system according to a first modified example.
FIG. 29 is a view used to explain an exposure system according to a second modified example.
FIG. 30 shows a modified example in which of the exposure unit, a part excluding a lower end (light-emitting section) of a barrel of an electron beam irradiation device is exposed outside of the vacuum chamber.

### MODE FOR CARRYING OUT THE INVENTION

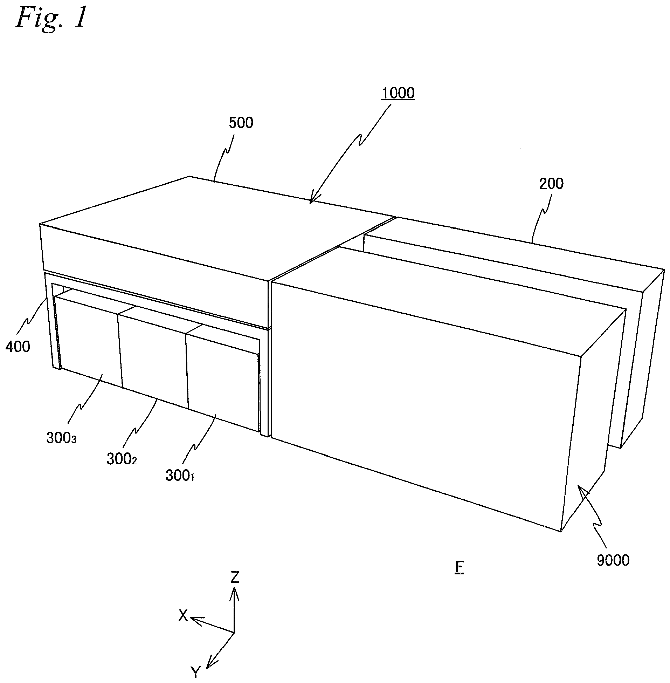

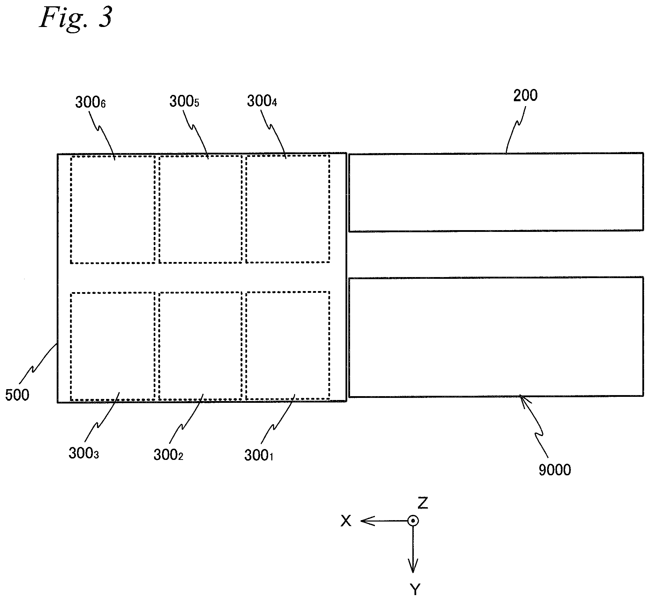

Hereinafter, an embodiment will be described below, based on FIGS. 1 to 27. FIGS. 1 to 2B each shows a perspective view of an exposure system 1000 according to an embodiment, along with a resist coating/developing apparatus (coater/developer (hereinafter shortly referred to as C/D)) 9000, seen from different directions. Also, FIG. 3 shows a planar view of exposure system 1000, along with C/D 9000.

In the embodiment, as an example of a charged particle beam, a structure using an electron beam will be described. However, the charged particle beam is not limited to the electron beam and may also be a beam using charged particles such as an ion beam.

In the embodiment, since a plurality of electron beam optical systems are provided as it will be described later on, in the description below, a Z-axis will be an axis parallel to an optical axis of each of the electron beam optical systems, and a Y-axis and an X-axis will be axes being orthogonal to each other within a plane surface perpendicular to the Z-axis (in the embodiment, a surface parallel to a floor surface F) .

Exposure system 1000, as is shown in FIGS. 1 to 3, is equipped with a rectangular solid shaped first control rack 200 placed facing rectangular solid shaped C/D 9000 installed on floor surface F partitioned by a predetermined spacing at the -Y side, a plurality of, e.g. six, chambers 300₁ to 300₆ arranged at the +X side of C/D 9000 and the first control rack 200, a frame 400 that has four leg sections positioned at four corners of the space where the six chambers 300₁ to 300₆ are arranged, and a second control rack 500 arranged on frame 400.

The six chambers 300₁ to 300₆ are divided into two rows consisting of three chambers 300₁ to 300₃ and three chambers 300₄ to 300₆.

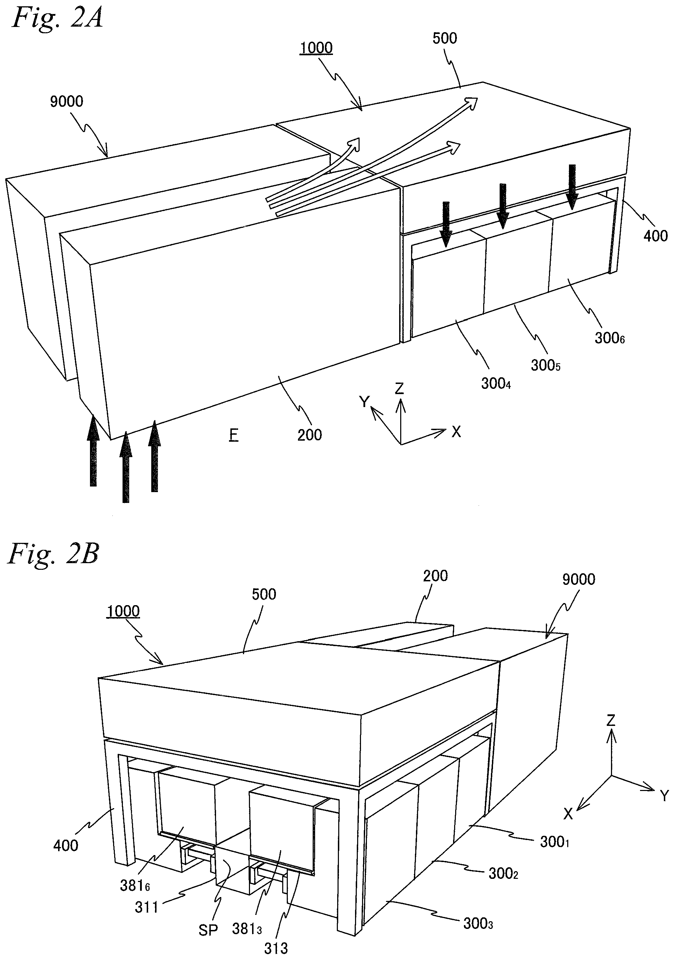

The three chambers 300₁ to 300₃ are arranged spaced apart from one another by a predetermined spacing in the X-axis direction (the direction in which chamber 300₁ and C/D 9000 to be described later are adjacent), and the three chambers 300₄ to 300₆ shown in FIG. 2A are arranged spaced apart from one another by a predetermined spacing in the X-axis direction (the direction in which chamber 300₄ and the first control rack 200 to be described later are adjacent).

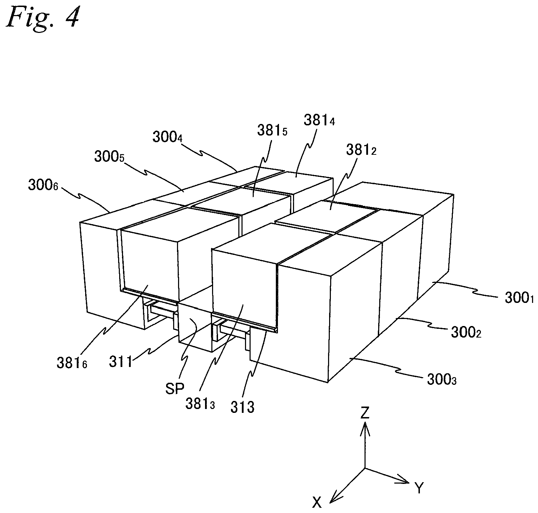

Chambers 300₁ to 300₃ shown in FIG. 1 are included in one row, and chambers 300₄ to 300₆ shown in FIG. 2A are included in the other row. As is shown in a planar view in FIG. 3, chambers 300₁ to 300₃ in one of the rows are arranged side by side in the X-axis direction adjacent to C/D 9000 on the +X side. Chambers 300₄ to 300₆ in the other row are arranged side by side in the X-axis direction adjacent to the first control rack 200 on the +X side. In the embodiment, as it can be seen from FIG. 4 that shows exposure system 1000 excluding the first control rack 200, frame 400, and the second control rack 500 and from FIG. 3, chamber 300₁ faces chamber 300₄, chamber 300₂ faces chamber 300₅, and chamber 300₃ faces chamber 300₆.

In other words, of the six chambers 300₁ to 300₆, chamber 300₁ is arranged adjacent to C/D 9000 in a direction that C/D 9000 extends.

Also, of the six chambers 300₁ to 300₆, chamber 300₄ is arranged in a direction intersecting the direction in which chamber 300₁ and C/D 9000 are adjacent, with chamber 300₄ being spaced apart by a predetermined spacing from chamber 3001. That is, chamber 300₄ and 300₁ are arranged facing each other.

The first control rack 200 is arranged spaced apart from chamber 300₄ and from C/D 9000 by a predetermined spacing. That is, chamber 300₄ is arranged adjacent to the first rack 200 in a direction that the first control rack 200 extends, and C/D 9000 is arranged facing the first control rack 200.

As the first control rack 200, a rectangular solid shaped object that has the same length and the same height as C/D 9000 is used. Also, since the six chambers 300₁ to 300₆ are structured so that the height is made to be lower than the height of the first control rack 200 and C/D 9000, an empty space is made above the six chambers 300₁ to 300₆. Therefore, in the embodiment, the second control rack 500 is arranged via frame 400, so as to effectively use this empty space. That is, frame 400 has a rectangular shaped top plate section and four leg sections of the same length that support the top plate section at the four corners, and supports the second control rack 500 from below. The upper surface of the second control rack 500 is almost flush with the upper surface of the first control rack 200 and C/D 9000.

Such layout in the embodiment allows a rectangular solid shaped space to be made inside the clean room, and makes it possible to avoid inconvenient space from being made in the clean room and to improve space utilization efficiency.

To the first control rack 200, wiring and piping from a utility supply source in a subfab of the clean room below floor surface F where production support equipment and utility facility are housed are connected from below, via floor surface F (refer to the three black arrows pointing upward in FIG. 2A). Also, the first control rack 200 is connected to the second control rack 500 via the piping and wiring. The wiring and piping are for supplying utilities (utility, resource) such as electric power, and other than electric power, utilities include air, cooling water, vacuum exhausting and the like.

Inside the first control rack 200, various units are housed such as a control system unit directly related to the electron beam exposure apparatus, e.g. a high voltage power supply and an amplifier, a control system of a stage which will be described later on, and a control board of a measurement system which will be described later on. The first control rack 200 supplies the utilities temporarily relayed to the wiring and piping supplied from the utility supply source in the subfab of the clean room via the wiring and piping (supply members) to the second control rack 500, so as to distribute the utilities to the six chambers 300₁ to 300₆ (refer to the outlined arrows in FIG. 2A). Note that a temperature controller of the cooling water may be arranged inside the first control rack 200 if necessary.

Inside the second control rack 500 as well, various units are housed similarly to the first control rack that are connected to each of the six chambers 300₁ to 300₆ via the wiring and piping. The second control rack 500 supplies the utilities supplied from the first control rack 200 to each of the six chambers 300₁ to 300₆ from above (refer to the three black arrows pointing downward in FIG. 2A). That is, the second control rack 500 functions as an interface between the first control rack 200 and the six chambers 300₁ to 300₆. The advantages of supplying the utilities from above to each of the six chambers 300₁ to 300₆ will be described later on.

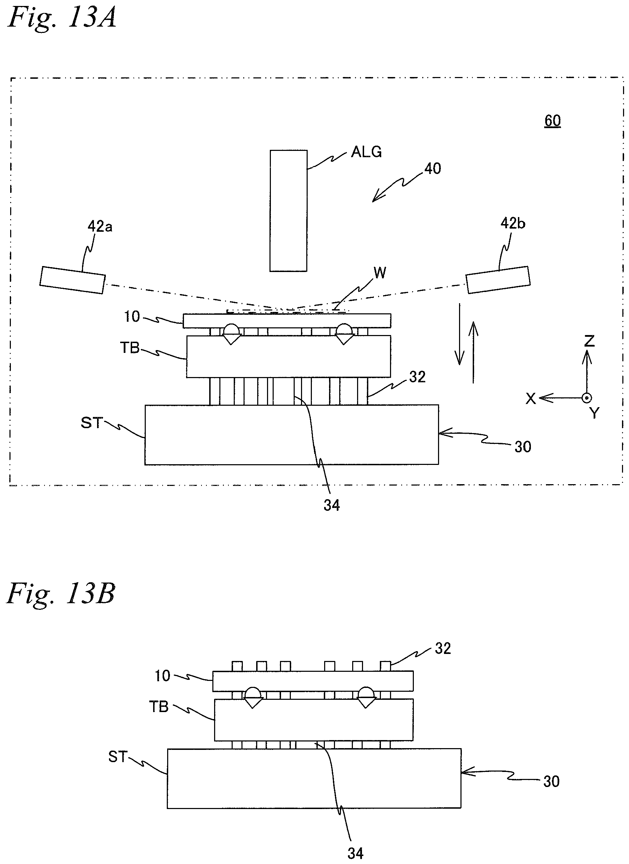

Of the six chambers 300₁ to 300₆, chamber 300₁ arranged adjacent to C/D 9000 has a rectangular solid shape (refer to FIG. 4). Chamber 300₁ is connected in-line to C/D 9000. The inner space of chamber 300₁ is a measurement chamber (measurement cell) 60 (not shown in FIGS. 1 to 2B, refer to FIG. 13A) where a predetermined measurement to a wafer serving as a target (a wafer on which an electron beam resist is coated by C/D 9000), loading of a wafer before exposure and unloading of a wafer that has been exposed to/from a wafer shuttle to be described later on are performed.

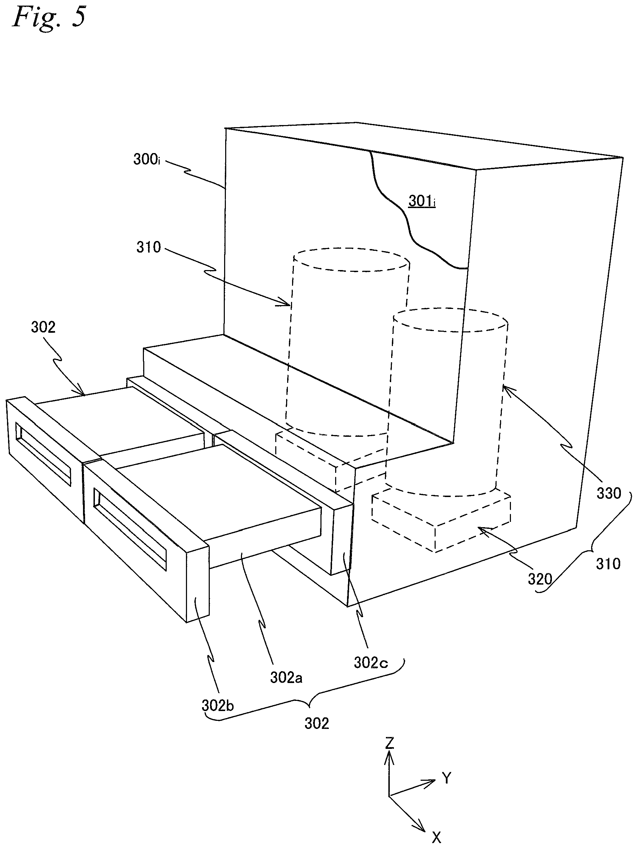

Of the five remaining chambers 300₂ to 300₆, chambers 300₄ to 300₆ have an L-shape when viewed from the +X side, and chambers 300₂ and 300₃ have a shape symmetric to chambers 300₄ to 300₆. The inner space of each of the five chambers 300₂ to 300₆ is an exposure chamber (exposure cell) 301ᵢ (i=2 to 6) (not shown in FIGS. 1 to 3 and the like, refer to FIG. 5) where exposure on the wafer is performed with the electron beam. The inside of exposure chamber 301ᵢ is maintained in a high vacuum state. That is as the five chambers 300ᵢ having exposure chamber 301ᵢ formed inside, a vacuum chamber is used that has sufficient durability so that the chamber is not crushed or deformed by the effect of atmospheric pressure. Hereinafter, chambers 300₂ to 300₆ will also be described as vacuum chambers 300₂ to 300₆.

Note that since the inner space of chamber 300₁ is a measurement chamber as is described above, a vacuum atmosphere like the inner space of chambers 300₂ to 300₆ does not have to be made. Therefore, as chamber 300₁, a chamber weaker in strength than the vacuum chamber can be used. Also, by controlling pressure of the inner space of chamber 300₁ and the pressure of the inner space of C/D 9000 so that the pressure therein is higher than the atmospheric pressure of the clean room, gas (air) in the clean room can be kept from entering inside chamber 300₁ and C/D 9000. Note that in each of the first control rack 200 and the second control rack 500, the inner space may be set to the same pressure (atmospheric pressure space) as the clean room or to a higher pressure than that of the clean room.

To vacuum chamber 300ᵢ, as is shown in FIG. 5, a pair of load lock chambers 302 is attached to the front surface. Note that while FIG. 5 shows a vacuum chamber in the same direction as vacuum chambers 300₃ and 300₂, vacuum chambers 300₆, 300₅, and 300₄ are arranged symmetric to the chamber in FIG. 5 but having a similar structure.

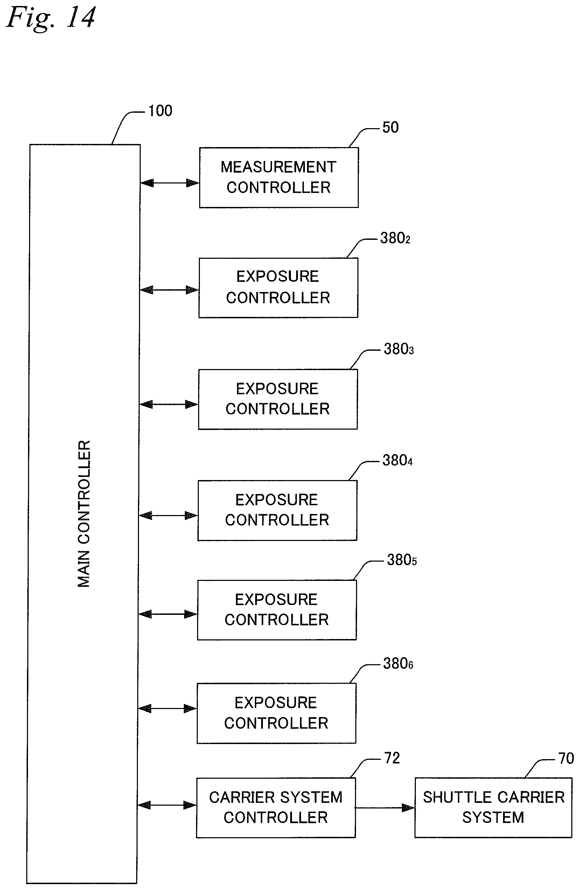

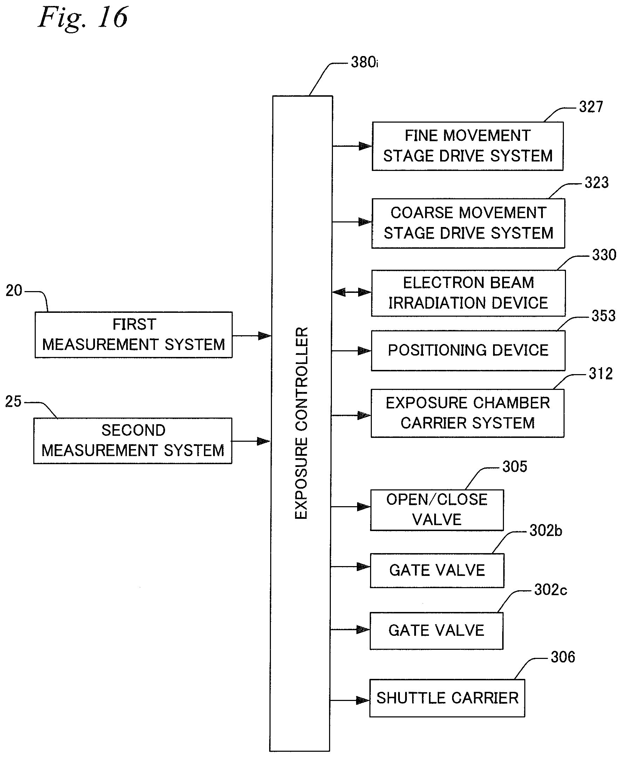

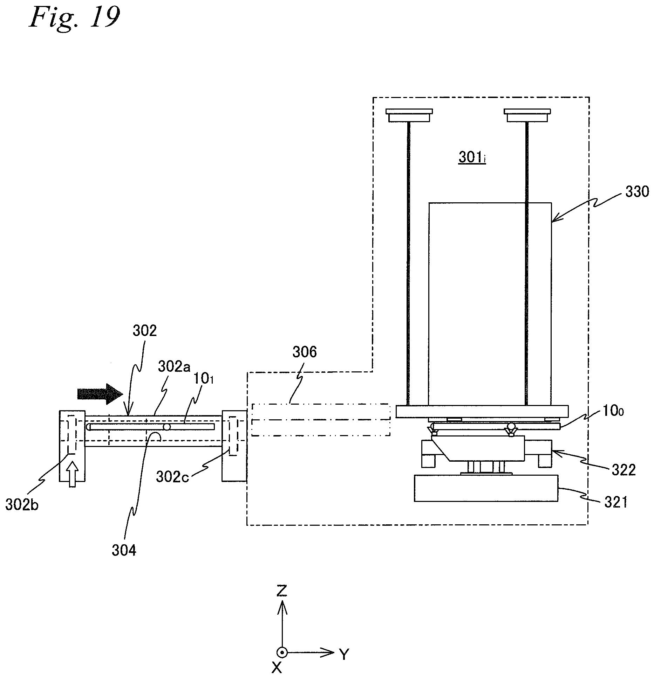

Each load lock chamber 302 includes a main section 302a in which a load lock chamber 304 (e.g. refer to FIG. 19) is formed and a pair of gate sections 302b and 302c fixed to the front surface side (atmosphere side) and the rear surface side (vacuum side) of main section 302a. In the pair of gate sections 302b and 302c, gate valves are provided consisting of shutters which open/close openings formed at the front surface side and the rear surface side of main section 302a and drive mechanisms which move the shutters by sliding the shutters in the vertical direction. In the description below, the gate valves will be described as gate valves 302b and 302c, using the same reference codes as the gate sections. Opening/closing of gate valves 302b and 302c (that is, opening/closing of the shutter by the drive mechanism) is controlled by an exposure controller 380ᵢ (refer to FIGS. 14 and 16).

To load lock chamber 302, a vacuum piping connected to a vacuum source such as a vacuum pump via an open/close valve 305 (refer to FIG. 16) is connected, and by opening open/close valve 305, evacuation of the inside of load lock chamber 304 is performed as necessary. The opening/closing of open/close valve 305 is also controlled by exposure controller 380ᵢ. Note that the vacuum pump may be provided individually to each of the load lock chambers 302.

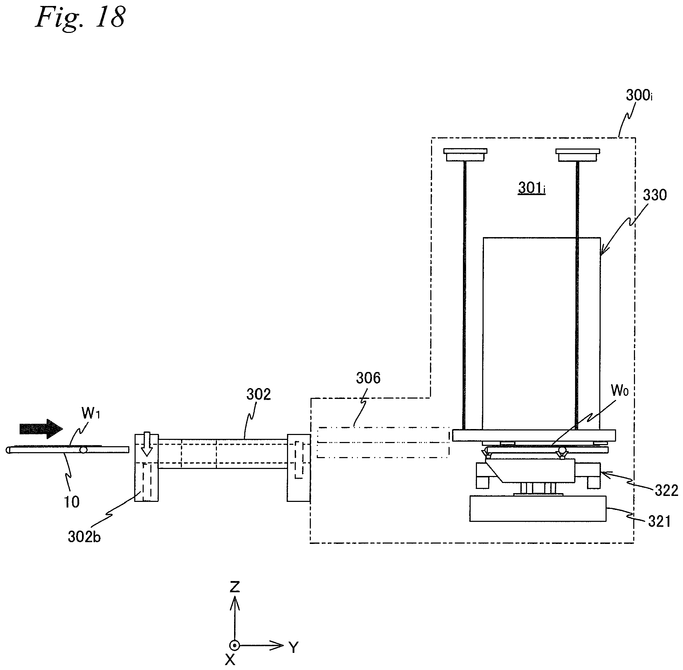

Inside exposure chamber 301ᵢ of vacuum chamber 300ᵢ, a pair of exposure units 310 shown in FIG. 5 and an exposure chamber carrier system 312 consisting of, for example, a horizontal articulated robot (not shown in FIG. 5, refer to FIG. 16) are housed. Also, although it is not shown in FIG. 5, in exposure chamber 301ᵢ, as is shown in FIG. 18 and the like, for example, a shuttle carrier 306 that is vertically movable and has two shelves arranged vertically apart by a first distance is provided. The vertical movement of shuttle carrier 306 is controlled by exposure controller 380ᵢ (refer to FIG. 16).

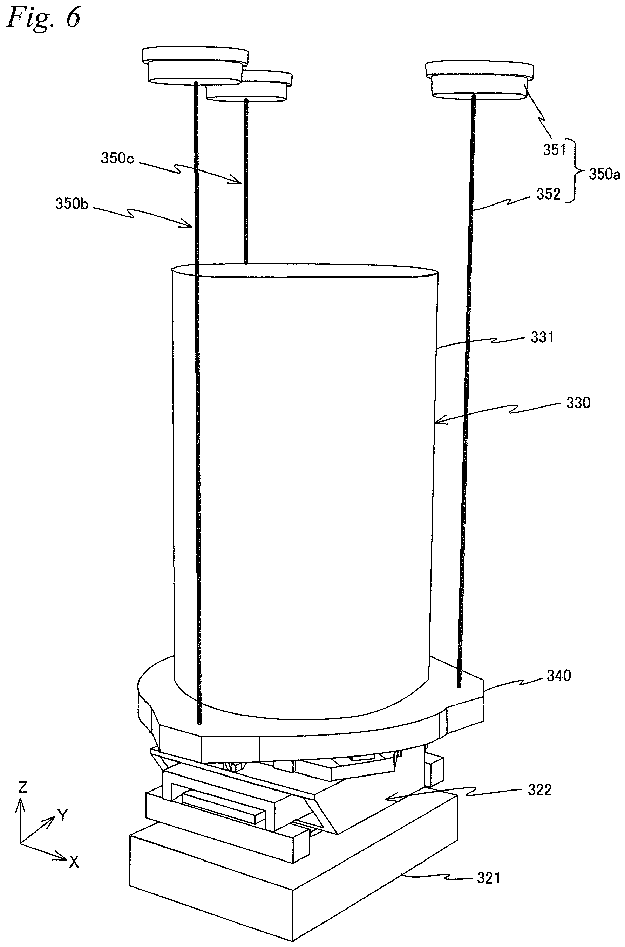

Exposure unit 310, as is shown simplified in FIG. 5, includes a stage device 320 and an electron beam irradiation device 330. Electron beam irradiation device 330 has a cylindrical barrel 331 shown in FIG. 6 and an electron beam optical system inside barrel 331.

Stage device 320 is structured including a coarse/fine movement stage that has a freely detachable wafer shuttle which can move holding the wafer, and electron beam irradiation device 330 is structured to irradiate and expose the wafer held by the wafer shuttle attached to the coarse/fine movement stage with an electron beam.

Here, although the details will be described later on, the wafer shuttle is a holding member (or a table) that holds the wafer by electrostatic suction, and is called a wafer shuttle because the holding member is carried in a state where the holding member holds the wafer, and is moved back and forth repeatedly like a shuttle bus (or a space shuttle) between each of the exposure chambers 301₂ to 301₆ and measurement chamber 60 serving as a starting point.

Stage device 320, as is shown in FIG. 6, is equipped with a surface plate 321 and a coarse/fine movement stage 322 which moves on surface plate 321, a drive system that moves coarse/fine movement stage 322, and a position measurement system that measures position information of the coarse/fine movement stage. Details on the structure and the like of stage device 320 will be described later on.

Barrel 331 of electron beam irradiation device 330, as is shown in FIG. 6, is supported from below by a metrology frame 340 consisting of a ring-shaped plate member that has three projecting sections formed in the outer periphery section arranged apart at a center angle of 120 degrees. More specifically, the lowermost end of barrel 331 is a small diameter section whose diameter is smaller than that of the upper part, and the border of the small diameter section and the upper part is a step section. And, in a state where the small diameter section is inserted into a circular opening of metrology frame 340 and the bottom surface of the step section is in contact with the upper surface of metrology frame 340, barrel 331 is supported from below by metrology frame 340. Metrology frame 340, as is shown in FIG. 6, is supported in a suspended state from a top plate (ceiling wall) of vacuum chamber 300ᵢ that divides exposure chamber 301ᵢ, via three suspension support mechanisms 350a, 350b, and 350c (connecting members having a flexible structure) whose lower ends are connected to the three projecting sections described earlier, respectively. That is, in the manner described above, electron beam irradiation device 330 is supported by suspension at three points with respect to vacuum chamber 300ᵢ.

The three suspension support mechanisms 350a, 350b, and 350c, as is representatively shown in suspension support mechanism 350a in FIG. 6, each has a passive vibration isolation pad 351 provided at the upper end of each of the suspension support mechanisms, and a wire 352 made of steel having one end connected to the lower end of vibration isolation pad (vibration isolation section) 351 and the other end connected to metrology frame 340. Vibration isolation pad 351 is fixed to the top plate of vacuum chamber 300ᵢ, and each includes an air damper or a coil spring.

In the embodiment, of vibration such as floor vibration transmitted from the outside to vacuum chamber 300ᵢ, since a large part of the vibration component in the Z-axis direction parallel to the optical axis of the electron beam optical system is absorbed by vibration isolation pad 351, high vibration isolation performance can be obtained in the direction parallel to the optical axis of the electron beam optical system. Also, natural frequency of the suspension support mechanism is lower in a direction perpendicular to the optical axis than in the direction parallel to the optical axis of the electron beam optical system. Since the three suspension support mechanisms 350a, 350b, and 350c vibrate like a pendulum in the direction perpendicular to the optical axis, the length (length of wire 352) of the three suspension support mechanisms 350a, 350b, and 350c is set long enough so that the vibration isolation performance (capacity of preventing vibration such as floor vibration transmitted from the outside to vacuum chamber 300ᵢ from travelling to electron beam irradiation device 330) in the direction perpendicular to the optical axis becomes sufficiently high. In this structure, while high vibration isolation performance can be obtained along with being able to largely reduce the weight of the mechanism section, relative position between electron beam irradiation device 330 and vacuum chamber 300ᵢ may change at a comparatively low frequency. Therefore, in order to maintain the relative position between electron beam irradiation device 330 and vacuum chamber 300ᵢ to a predetermined state, a positioning device 353 (not shown in FIG. 5, refer to FIG. 16) of a non-contact method is provided. This positioning device 353 can be structured including a six-axis acceleration sensor and a six-axis actuator, as is disclosed in, for example, International Publication WO 2007/077920, and the like. Positioning device 353 is controlled by exposure controller 380ᵢ (refer to FIG. 16). This allows the relative position of electron beam irradiation device 330 in the X-axis direction, the Y-axis direction, the Z-axis direction and relative rotation angle around the X-axis, the Y-axis, and the Z-axis with respect to vacuum chamber 300ᵢ to be maintained at a constant state (a predetermined state) .

In the embodiment, electron beam irradiation device 330 is equipped with an electron beam optical system structured from m (m is, for example, 100) optical system columns arranged in a predetermined positional relation inside barrel 331. Each optical system column is consisting of a multi-beam optical system that can be separately turned on/off and can irradiate n (n is, for example, 4000) deflectable beams. As the multi-beam optical system, a system can be used that has a structure similar to the optical system disclosed in, for example, Japanese Unexamined Patent Application Publication No. 2011-258842, International Publication WO 2007/017255, and the like. When the 4000 multi-beams are all in an on state (a state in which the wafer is irradiated with the electron beams), circular spots of the electron beams smaller than (e.g. a diameter of 20 nm) the resolution limit of the ultraviolet ray exposure apparatus are formed simultaneously at 4000 points set at an equal spacing within, for example, a 100 µm × 20 nm rectangular area (exposure area).

The 100 optical system columns correspond almost one to one, to for example, 100 shot areas formed (or will be formed according to a shot map), for example, on a 300 mm wafer. In the embodiment, each of the 100 optical system columns can be turned on/off, and by arranging a circular spot of deflectable multiple (n=4000) electron beams having a 20 nm diameter in a rectangular (e.g. 100 µm × 20 nm) exposure area and turning on/off the circular spots while performing deflection of the multiple electron beams while the wafer is scanned with respect to this exposure area, 100 shot areas are exposed on the wafer and a pattern formed thereon. Accordingly, in the case of a 300 mm wafer, tens of millimeters, e.g. 50 mm, is enough for movement strokes of the wafer on exposure even with some margin. Each optical system column is equipped with a reflected electron detection system (not shown) that detects reflected electrons, similarly to a normal electron beam optical system. Electron beam irradiation device 330 is controlled by exposure controller 380 (refer to FIG. 16).

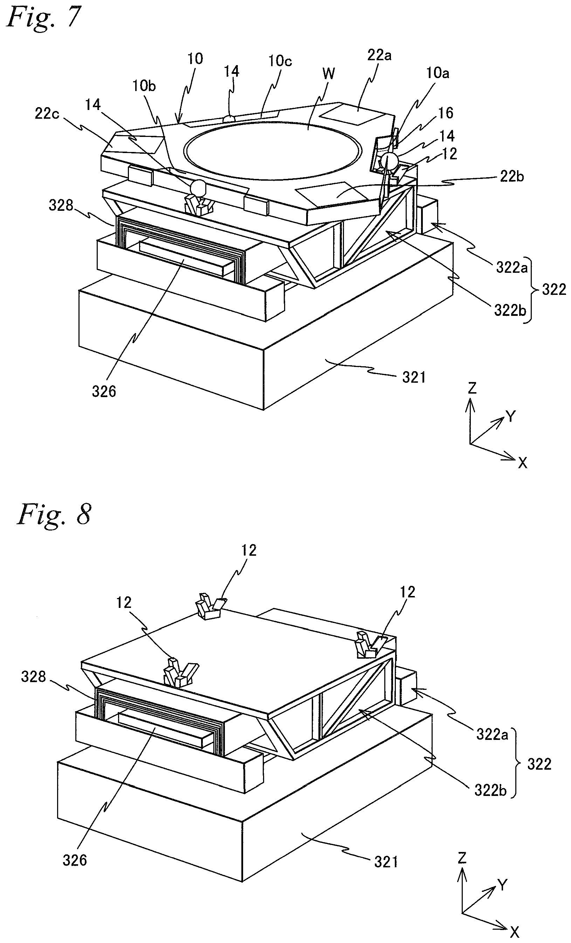

Next, the structure and the like of stage device 320 will be described. FIG. 7 shows a perspective view of coarse/fine movement stage 322 of stage device 320 in a state where a wafer shuttle (hereinafter shortly referred to as shuttle) 10 is attached. FIG. 8 shows a perspective view of coarse/fine movement stage 322 shown in FIG. 7 in a state where a shuttle 10 is detached (removed).

Surface plate 321 that stage device 320 has is actually installed on the bottom wall of vacuum chamber 300ᵢ that divides exposure chamber 301ᵢ. Coarse/fine movement stage 322, as is shown in FIGS. 7 and 8, is equipped with a coarse movement stage 322a, which is arranged apart by a predetermined spacing in the Y-axis direction including a pair of square column shaped parts each extending in the X-axis direction and is movable in the X-axis direction on surface plate 321 in predetermined strokes, e.g. 50 mm, and a fine movement stage 322b that can move in the Y-axis direction with respect to coarse movement stage 322a in predetermined strokes, e.g. 50 mm, and can move in shorter strokes than the Y-axis direction in the remaining directions of five degrees of freedom, that is, in the X-axis direction, the Z-axis direction, rotation direction around the X-axis (θx direction), rotation direction around the Y-axis (θy direction), and rotation direction around the Z-axis (θz direction) . Note that, although it is omitted in the drawings, the pair of square column shaped parts of coarse movement stage 322a is actually connected by a connecting member (not shown) and is integrated in a state where the square column shaped parts do not interfere with the movement of fine movement stage 322b in the Y-axis direction.

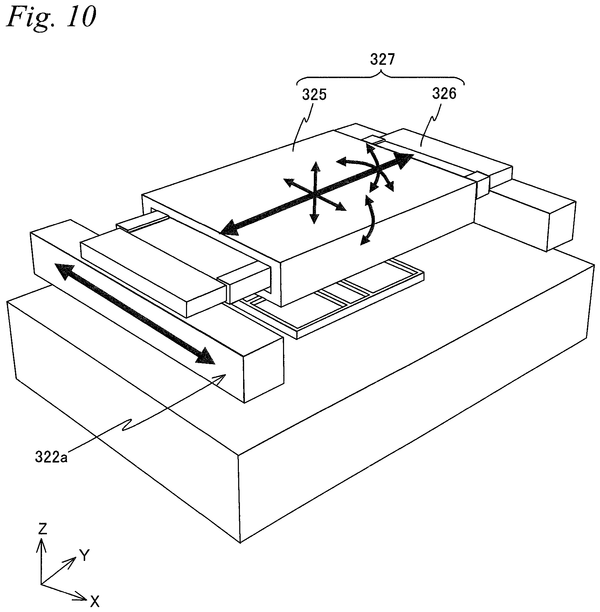

Coarse movement stage 322a is moved (refer to the long arrow in the X-axis direction in FIG. 10) in predetermined strokes (e.g. 50 mm) in the X-axis direction by coarse movement stage drive system 323 (refer to FIG. 16). Coarse movement stage drive system 323, in the embodiment, is structured employing a uniaxial drive mechanism which does not cause magnetic flux leakage, such as a feed screw mechanism using a ball screw. This coarse movement stage drive system 323 is arranged between one square column shaped part of the pair of square column shaped parts of the coarse movement stage and surface plate 321. For example, as a structure, a screw shaft is attached to surface plate 321, and a ball (nut) is attached to the one square column shaped part. Note that a structure of the ball being attached to surface plate 321, and the screw shaft being attached to the one square column shaped part may also be employed.

Also, of the pair of square column shaped parts of the coarse movement stage, the other square column shaped part is structured to move along a guide surface (not shown) provided on surface plate 321.

The screw shaft of the ball screw is rotationally driven by a stepping motor. Alternatively, coarse movement stage drive system 323 can be structured by a uniaxial drive mechanism equipped with an ultrasonic motor as a drive source. In any case, variation of magnetic field caused by the magnetic flux leakage does not have any influence on positioning of the electron beam. Coarse movement stage drive system 323 is controlled by exposure controller 380ᵢ (refer to FIG. 16).

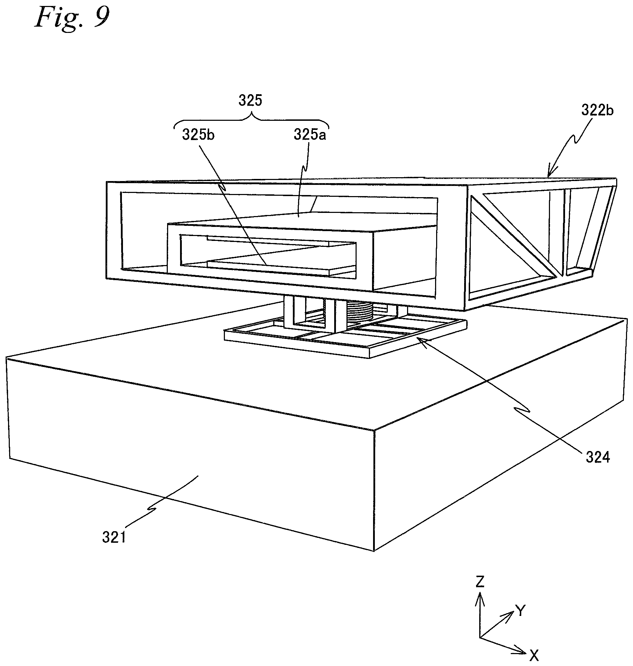

Fine movement stage 322b, as is shown enlarged in the perspective view in FIG. 9, consists of a frame shaped member penetrating in the Y-axis direction that has a rectangular XZ sectional surface, and is movably supported in the XY plane on surface plate 321 by a weight canceling device 324. On the outer surface of the side wall of fine movement stage 322b, a plurality of ribs for reinforcement is arranged. Note that the structure of weight canceling device 324 will be described later on.

Inside the hollow section of fine movement stage 322b, a yoke 325a extending in the Y-axis direction that has a rectangular frame shaped XZ cross sectional surface and a pair of magnet units 325b fixed to the vertical opposing surfaces of yoke 325a are provided, and these yoke 325a and the pair of magnet units 325b structure a mover 325 of the motor that moves fine movement stage 322b.

Corresponding to this mover 325, in between the pair of square column shaped parts of coarse movement stage 322a, a stator 326 consisting of a coil unit is laid as is shown in FIG. 10 showing a state where fine movement stage 322b and a magnetic shield member to be described later on shown by reference code 328 are removed from the state in FIG. 8. Stator 326 and mover 325 described earlier structure a closed magnetic field type and a moving magnet type motor 327 that moves mover 325 with respect to stator 326 in the Y-axis direction in predetermined strokes, e.g. 50 mm, and can finely move mover 325 in the X-axis direction, the Z-axis direction, the θx direction, the θy direction, and the θz direction, as is shown by the arrows pointing in each of the directions in FIG. 10. In the embodiment, motor 327 structures a fine movement stage drive system that moves the fine movement stage in directions of six degrees of freedom. Hereinafter, the fine movement stage drive system will be described as fine movement stage drive system 327, using the same reference code as the motor. Fine movement stage drive system 327 is controlled by exposure controller 380ᵢ (refer to FIG. 16).

In between the pair of square column shaped parts of coarse movement stage 322a, for example, as is shown in FIGS. 7 and 8, a magnetic shield member 328 having an inverse U-shape XZ section is laid further, in a state covering the upper surface of motor 327 and the surfaces on both sides in the X-axis direction. That is, magnetic shield member 328 is formed extending in a direction (the Y-axis direction) intersecting the direction in which the square column shaped parts extend, and is equipped with an upper surface section that faces the upper surface of motor 327 in a non-contact manner, and a side surface section that faces the side surface of motor 327 in a non-contact manner. This magnetic shield member 328, in a state inserted into the hollow section of fine movement stage 322b, has the lower surface at both ends in the longitudinal direction (the Y-axis direction) of the side surface sections fixed to the upper surface of the pair of square column shaped parts of coarse movement stage 322a. Also, of the side surface sections of magnetic shield member 328, the sections other than the lower surface at both ends described above face the bottom wall surface (lower surface) of the inner wall surface of fine movement stage 322b in a non-contact manner. That is, magnetic shield member 328 is inserted into the hollow section of fine movement stage 322b in a state without interrupting movement of mover 325 with respect to stator 326.

As magnetic shield member 328, a laminated magnetic shield member is used, structured of a plurality of layers of magnetic material films which are layered with a predetermined air-gap (space) in between. Other than this, a magnetic shield member having a structure in which films of two types of materials having different magnetic permeability are alternately layered may also be used. Since magnetic shield member 328 covers the upper surface and the side surfaces of motor 327 throughout the whole length of movement strokes of mover 325 and is also fixed to coarse movement stage 322a, in the whole movement range of fine movement stage 322b and coarse movement stage 322a, an upward magnetic flux leakage (to the electron beam optical system side) can be prevented almost without fail.

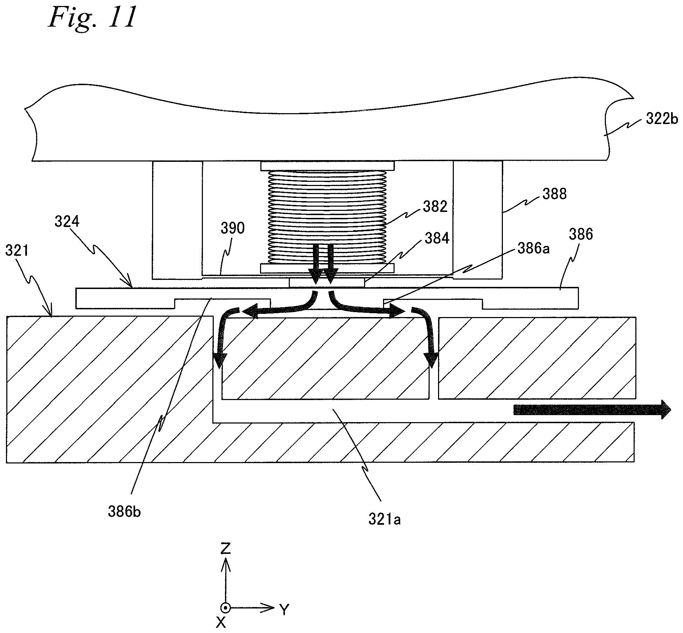

Weight canceling device 324, as is shown in FIG. 11, has a metal bellows type air spring (hereinafter shortly referred to as air spring) 382 whose upper end is connected to the lower surface of fine movement stage 322b, and a base slider 386 consisting of a tabular plate member connected to the lower end of air spring 382. Air spring 382 and base slider 386 are connected to each other via a plate shaped connecting member 384 that has an opening formed in the center.

To base slider 386, a bearing section 386a that blows out the air inside air spring 382 to the upper surface of surface plate 321 is provided below air spring 382, and static pressure (pressure in gap) between a bearing surface of pressurized air blown out from bearing section 386a and the upper surface of surface plate 321 supports the self-weight of base slider 386, weight canceling device 324, fine movement stage 322b, and mover 325 (including shuttle 10 and the like in the case the shuttle is attached to coarse/fine movement stage 322 to be described later on). Note that to air spring 382, pressurized air is supplied via piping (not shown) connected to fine movement stage 322b.

In a surface (lower surface) facing surface plate 321 of base slider 386, a ring-shaped recess section 386b is formed in the periphery of bearing section 386a, and corresponding to this in surface plate 321, an exhaust passage 321a is formed for vacuum exhausting to the outside the air blown out from bearing section 386a into the space divided by recess section 386b and the upper surface of surface plate 321. Recess section 386b of base slider 386 has a dimension in which a state where the exhaust port of exhaust passage 321a faces recess section 386b can be maintained, no matter where fine movement stage 322b moves in the movable range within the XY plane on surface plate 321. That is, a kind of differential exhausting type air hydrostatic bearing is structured below base slider 386, which prevents the air blown out from bearing section 386a to surface plate 321 from leaking out to the surroundings (into the exposure chamber).

To the lower surface of 322b, a pair of support columns (pillars) 388 is fixed with air spring 382 in between. The pair of support columns 388 is arranged at both sides in the X-axis direction of air spring 382, also in a symmetric arrangement with air spring 382 in the center, and with the length in the Z-axis direction slightly longer than air spring 382. To each of the lower ends of the pair of support columns 388, one end of a pair of plate springs 390 each having a U-shape in a planar view is connected, and the other end of the pair of plate springs 390 is connected to the lower end surface of air spring 382. In this case, the pair of plate springs 390 has the tip of the U-shape (the part branched into two) connected to air spring 382, and the end on the opposite side each connected to the pair of support columns 388. The pair of plate springs 390 is almost parallel to base slider 386, and a predetermined spacing is formed between the two.

Since the pair of plate springs 390 can receive the horizontal force that acts on base slider 386 when fine movement stage 322b moves within the XY plane, this can prevent unnecessary force from acting on air spring 382 almost without fail when fine movement stage 322b moves within the XY plane. Also, the pair of plate springs 390 deforms to allow tilt when tilt drive of fine movement stage 322b is performed.

Now, a structure will be described to freely attach/detach shuttle 10 to/from coarse/fine movement stage 322, or to be more precise, fine movement stage 322b.

On the upper surface of fine movement stage 322b, as is shown in FIG. 8, three triangular pyramid groove members 12 are provided. These triangular pyramid groove members 12 are provided, for example, at positions being the three vertices of an equilateral triangle in a planar view. With this triangular pyramid groove member 12, a spherical body or a hemispherical body provided in shuttle 10 to be described later on can be engaged, and kinematic coupling is structured by the triangular pyramid groove member along with the spherical body or the hemispherical body. Note that although FIG. 8 shows a petal-like triangular pyramid groove member 12 structured by three plate members, this triangular pyramid groove member has the same role as a triangular pyramid groove that makes point contact with a spherical body or a hemispherical body, therefore, is referred to as a triangular pyramid groove member. Accordingly, a single member in which a triangular pyramid groove is formed may be used instead of triangular pyramid groove member 12.

In the embodiment, corresponding to the three triangular pyramid groove members 12, as is shown in FIG. 7, three spherical bodies or hemispherical bodies (balls in the embodiment) 14 are provided in shuttle 10. Shuttle 10 is formed in a hexagonal shape made when cutting off the three vertices of an equilateral triangle in a planar view. To describe this more in detail, in shuttle 10, cutout sections 10a, 10b, and 10c are formed in each of the centers of three oblique sides in a planar view, and plate springs 16 are attached, respectively, in a state covering cutout sections 10a, 10b, and 10c from the outer side. Each of the plate springs 16 has ball 14, which is fixed in the center of the plate spring in the longitudinal direction. In a state before being engaged with triangular pyramid groove member 12, each ball 14 finely moves only in a radius direction centering on the center of shuttle 10 (almost coincides with the center of wafer W shown in FIG. 7) when receiving external force.

After shuttle 10 is moved to a position where the three balls 14 each faces the three triangular pyramid groove members 12 above fine movement stage 322b, by moving shuttle 10 downward, each of the three balls 14 engages with the three triangular pyramid groove members 12 individually, and shuttle 10 is attached to fine movement stage 322b. At the time of this attachment, even if the position of shuttle 10 with respect to fine movement stage 322b is shifted from a desired position, ball 14 moves in the radius direction as is mentioned above by receiving external force from triangular pyramid groove member 12 when ball 14 engages with triangular pyramid groove member 12, and as a result, the three balls 14 engage with the corresponding triangular pyramid groove members 12 constantly in the same state. On the other hand, by moving shuttle 10 upward and only releasing the engagement of balls 14 and triangular pyramid groove members 12, shuttle 10 can be removed (detached) easily from fine movement stage 322b. That is, in the embodiment, three sets of ball 14 and triangular pyramid groove member 12 as a set structure a kinematic coupling, and this kinematic coupling allows the attachment state of shuttle 10 to fine movement stage 322b to be set constantly almost in the same state. Accordingly, no matter how many times shuttle 10 is removed, by only attaching shuttle 10 to fine movement stage 322b via the kinematic coupling (three sets of ball 14 and triangular pyramid groove member 12 as a set) again, a constant positional relation between shuttle 10 and fine movement stage 322b can be reproduced.

On the upper surface of shuttle 10, as is shown in FIG. 7, for example, a circular recess section whose diameter is slightly larger than wafer W is formed in the center, and within the recess section, an electrostatic chuck (not shown) is provided, which suctions and holds wafer W electrostatically. In this holding state of wafer W, the surface of wafer W is almost flush with the upper surface of shuttle 10. In shuttle 10, a plurality of circular openings (not shown) is formed in a predetermined positional relation, vertically penetrating a mounting surface (suction surface) of wafer W.

Next, a position measurement system that measures position information of coarse/fine movement stage 322 will be described. This position measurement system measures position information of shuttle 10 in a state where shuttle 10 is attached to fine movement stage 322b via the kinematic coupling previously described. This position measurement system includes a first measurement system 20 that measures position information of fine movement stage 322b to which shuttle 10 is attached, and a second measurement system 25 that directly measures position information of fine movement stage 322b (refer to FIG. 16).

First of all, the first measurement system 20 will be described. Near each of the three sides excluding the three oblique sides described earlier of shuttle 10, as is shown in FIG. 7, grating plates 22a, 22b, and 22c are provided. On each of the grating plates 22a, 22b, and 22c, a two-dimensional grating is formed whose periodic direction is in the radius direction centering on the center of shuttle 10 (coincides with the center of the circular recess section in the embodiment) and a direction orthogonal to this direction. For example, on grating plate 22a, a two-dimensional grating whose periodic direction is in the Y-axis direction and the X-axis direction is formed. Also, on grating plate 22b, a two-dimensional grating is formed whose periodic direction is in a direction at a -120 degree angle from the Y-axis originating from the center of shuttle 10 (hereinafter referred to as an α direction) and a direction orthogonal to this direction, and on grating plate 22c, a two-dimensional grating is formed whose periodic direction is in a direction at a +120 degree angle from the Y-axis originating from the center of shuttle 10 (hereinafter referred to as a β direction) and a direction orthogonal to this direction. As the two-dimensional grating, for example, a reflective diffraction grating having a pitch of 1 µm for each direction is used.

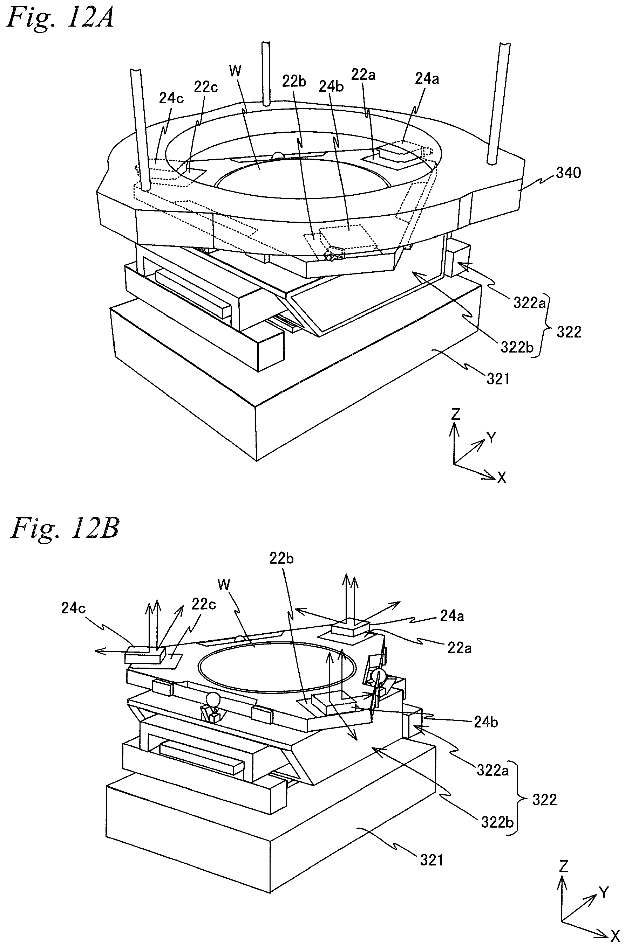

Corresponding to the three grating plates 22a, 22b, and 22c, as is shown in FIG. 12A, three head sections 24a, 24b, and 24c are fixed to the lower surface (surface at the -Z side) of metrology frame 340 at positions where the heads can individually face grating plates 22a, 22b, and 22c, respectively. In each of the three head sections 24a, 24b, and 24c, a four-axis encoder head having measurement axes shown by the four arrows in FIG. 12B is provided.

To describe this more in detail, head section 24a includes a first head whose measurement direction is in the X-axis direction and the Z-axis direction and a second head whose measurement direction is in the Y-axis direction and the Z-axis direction that are housed in the same housing. The first head (to be more precise, an irradiation point on grating plate 22a of a measurement beam emitted by the first head) and the second head (to be more precise, an irradiation point on grating plate 22a of a measurement beam emitted by the second head) are arranged on the same straight line parallel to the X-axis. The first head and the second head of head section 24a each uses grating plate 22a, and each structures a two-axis linear encoder that measures position information of shuttle 10 in the X-axis direction and the Z-axis direction and a two-axis linear encoder that measures position information of shuttle 10 in the Y-axis direction and the Z-axis direction.

Although the remaining head sections 24b and 24c are each arranged in different directions with respect to metrology frame 340 (measurement directions within the XY plane differ), the head sections have a similar structure as head section 24a including the first head and the second head. The first head and the second head of head section 24b each uses grating plate 22b, and each structures a two-axis linear encoder that measures position information of shuttle 10 in a direction orthogonal to the α direction within the XY plane and the Z-axis direction and a two-axis linear encoder that measures position information in the α direction and the Z-axis direction. The first head and the second head of head section 24c each uses grating plate 22c, and each structures a two-axis linear encoder that measures position information of shuttle 10 in a direction orthogonal to the β direction within the XY plane and the Z-axis direction and a two-axis linear encoder that measures position information in the β direction and the Z-axis direction.

As each of the first head and the second head that each of the head sections 24a, 24b, and 24c has, an encoder head having a structure similar to a displacement measurement sensor head disclosed in, for example, U.S. Patent No. 7,561,280 can be used.

The three head sections 24a, 24b, and 24c that measure position information of shuttle 10 using the three sets, or a total of six two-axis encoders described above, that is, three grating plates 22a, 22b, and 22c, respectively, structure an encoder system, and this encoder system structures the first measurement system 20 (refer to FIG. 16) . Position information measured by the first measurement system 20 is supplied to exposure controller 380ᵢ.

The first measurement system 20 can perform measurement in a total of twelve degrees of freedom, since the three head sections 24a, 24b, and 24c each has four degrees of freedom (measurement axes) on measurement. That is, since the degree of freedom in a three-dimensional space is six at most, measurement is actually performed redundantly for each of the directions of six degrees of freedom so that two each of position information is obtained.

Accordingly, based on position information measured by the first measurement system 20, exposure controller 380ᵢ uses an average value of the two each of the position information for each degree of freedom as the measurement result for each direction. This makes it possible to obtain position information of shuttle 10 and fine movement stage 322b with high precision for all directions of six degrees of freedom by the averaging effect.

Next, the second measurement system 25 will be described. The second measurement system 25 can measure position information of fine movement stage 332b in directions of six degrees of freedom, regardless of whether or not shuttle 10 is attached to fine movement stage 332b. The second measurement system 25 can be structured, for example, by an interferometer system that irradiates a reflection surface provided on the outer surface of the side wall of fine movement stage 332b with a beam, receives the reflection light, and measures position information of fine movement stage 332b in directions of six degrees of freedom. Each interferometer of the interferometer system may be supported by suspension from metrology frame 340 via a support member (not shown), or may be fixed to surface plate 321. Since the second measurement system is provided within exposure chamber 301ᵢ (inside vacuum space), there is no risk of measurement accuracy decreasing due to air fluctuation. Also, since the second measurement system 25 is used in the embodiment mainly to maintain position and attitude of fine movement stage 332b in a desired state when shuttle 10 is not attached to fine movement stage 332b, that is, when exposure of the wafer is not performed, the measurement accuracy may be lower than that of the first measurement system 20. Position information measured by the second measurement system 25 is supplied to exposure controller 380i (refer to FIG. 16). Note that the second measurement system is not limited to an interferometer system, and may also be structured by an encoder system, or a combination of an encoder system and an interferometer system. In the latter case, position information of fine movement stage 322b in directions of three degrees of freedom within the XY plane may be measured with the encoder system, and position information in the remaining directions of three degrees of freedom may be measured by the interferometer system.

In the embodiment, load lock chamber 302 that each of the vacuum chambers 300₂ to 300₆ is equipped with is arranged lined in the X-axis direction similar to vacuum chambers 300₂ to 300₆, therefore, load lock chamber 302 that each of the vacuum chambers 300₃ and 300₂ in one line is equipped with faces load lock chamber 302 that chamber 300₁ and each of the vacuum chambers 300₆, 300₅, and 300₄ in the other line is equipped with, spaced apart by a predetermined spacing. And, as is shown in FIGS. 2B and 4, between the opposing chambers, a carrier chamber 311 is provided that divides a carrier space SP extending in the X-axis direction and having a rectangular cross sectional surface. A moving route of a shuttle carrier system to be described later on is provided within carrier space SP. Note that although it is omitted in the drawings, in both of the side walls of carrier chamber 311, openings serving as a passage of shuttle 10 are formed at a position facing the gate section. Note that since carrier space SP can be set at a low vacuum space where the degree of vacuum is lower than that of the inside of the vacuum chamber such as at an atmospheric pressure space, carrier chamber 311 does not necessarily have to be used.

Exposure controllers 380₂, 380₃, 380₄, 380₅, and 380₆, as is shown in FIGS. 2B and 4, are housed inside control boxes 381₂, 381₃, 381₄, 381₅, and 381₆ arranged in the space above each of the load lock chambers 302 and at the inner side of vacuum chambers 300₂, 300₃, 300₄, 300₅, and 300₆, respectively. Note that control boxes 381₂, 381₃, 381₄, 381₅, and 381₆ are actually mounted on a support frame 313 installed between the vacuum chambers and carrier chamber 311, as is representatively shown for control box 381₃ in FIG. 2B. Support frame 313 is actually supported on floor surface F.

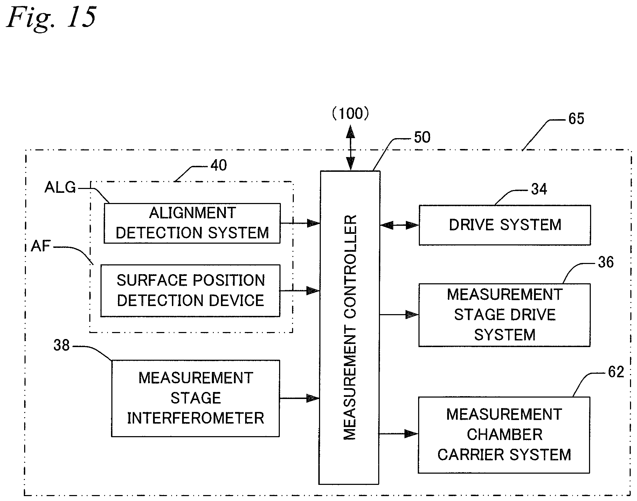

Next, a structure of the inside of measurement chamber 60 will be briefly described. In measurement chamber 60, as is shown in FIG. 13A, a measurement stage device 30 that has a measurement stage ST which moves two-dimensionally within the XY plane and a measurement table TB mounted on measurement stage ST, a measurement system 40, and a measurement chamber carrier system 62 (refer to FIG. 15) consisting of, e.g. an articulated robot, that carries wafer W and shuttle 10 are housed. With measurement stage device 30, shuttle 10 is attached freely detachable to measurement table TB via a kinematic coupling similar to the one described above. And then, measurement system 40 performs a predetermined measurement with respect to wafer W held on shuttle 10.

Other than this, inside measurement chamber 60, a shuttle stocker (not shown) is provided that has a plurality of layers of shelves for housing shuttle 10 so that a plurality of shuttles 10 can be housed. In the embodiment, the shuttle stocker also has a function of controlling the temperature of shuttle 10 that are housed. The structure, however, is not limited to this, and the temperature controlling device of the shuttles can be provided separate from the shuttle stocker. Note that while the carrier system for carrying the wafer and the carrier system for carrying the shuttle may be provided separately, in the embodiment, for the sake of simplifying the description, carriage of the wafer and the shuttle are to be performed by the same carrier system.

In measurement table TB, a plurality of circular openings are formed in correspondence with the plurality of circular openings described earlier formed in shuttle 10. In measurement stage ST, a plurality of pins 32 is protrusively provided in an arrangement corresponding to the plurality of circular openings, and measurement table TB is arranged on measurement stage ST in a state where the plurality of pins 32 is inserted individually into the plurality of circular openings of measurement table TB. Measurement table TB is moved by a drive system 34 provided at measurement stage ST, and is vertically movable (moves in the Z-axis direction) in predetermined strokes. In the embodiment, measurement table TB is vertically movable between a first position shown in FIG. 13A in which the upper surface of shuttle 10 is higher by a predetermined distance than the upper end surface of the plurality of pins 32 (the upper end surface of the plurality of pins does not project from the upper surface of shuttle 10) in a state where shuttle 10 is attached via kinematic coupling, and a second position shown in FIG. 13B in which a wafer mounting surface (upper surface of an electrostatic chuck) of shuttle 10 is lower by a predetermined distance than the upper end surface of the plurality of pins 32 (the upper end surface of the plurality of pins 32 projects from the wafer mounting surface of shuttle 10).

Note that measurement table TB may be mounted on measurement stage ST and the plurality of pins 32 may be moved vertically with respect to measurement table TB.

Measurement stage ST is moved (including rotation in the θz direction) within the XY plane by a measurement stage drive system 36 (refer to FIG. 15) consisting of, e.g. a planar motor. Position information of measurement stage ST in the XY plane is measured by a measurement stage interferometer 38 (refer to FIG. 15). Also, the position of measurement table TB in the vertical direction is measured by an encoder that drive system 34 has. The operation of each section of measurement stage device 30 is controlled by a measurement controller 50 (refer to FIG. 15).

Measurement system 40, as is shown in FIG. 13A, includes an alignment detection system ALG and a surface position detection device AF (refer to FIG. 15) that has an irradiation system 42a and a light-receiving system 42b.

In the embodiment, corresponding to a sensitive agent (resist for electron beam) coated on the upper surface of the wafer held on shuttle 10, a detection beam having a wavelength that does not expose the electron beam resist is used as the detection light of alignment detection system ALG. As alignment detection system ALG, for example, an FIA (Field Image Alignment) system of an image processing method is used that irradiates a subject mark with a broadband detection light flux which does not sensitize the resist coated on the wafer, forms an image of the subject mark formed on the light receiving surface by the reflection light from the subject mark and an image of an index (not shown) (an index pattern on an index plate provided inside) using an imaging device (such as a CCD), and outputs imaging signals. The imaging signals which are output from alignment detection system ALG, are to be supplied to measurement controller 50 (refer to FIG. 15) via a signal processor (not shown). Note that alignment detection system ALG is not limited to the FIA system, and instead of the FIA system, for example, a diffracted light interference type alignment detection system that performs detection by irradiating a target mark with a coherent detection light and making two diffracted lights (e.g. diffracted lights of the same order, or diffracted lights diffracted in the same direction) generated from the target mark interfere may be used.

Surface position detection device AF has irradiation system 42a and light-receiving system 42b, and is structured with a multi-point focal point detection system of an oblique incidence method having a structure similar to the one disclosed in, for example, U.S. Patent No. 5,448,332 and the like. A plurality of detection points of surface position detection device AF is arranged at a predetermined spacing along the X-axis direction on a surface subject to detection. In the embodiment, the detection points are arranged, for example, in the shape of a row matrix of one row M columns (M is the total number of detection points) or two rows N columns (N is 1/2 of the total number of detection points). Although it is omitted in the drawing in FIG. 13A, the plurality of detection points are set almost uniformly within an area having about the same length in the X-axis direction as the diameter of wafer W, therefore, by only scanning wafer W in the Y-axis direction once, position information (surface position information) in the Z-axis direction can be measured for the entire surface of wafer W. In the embodiment, each section arranged inside measurement chamber 60 described above, that is, measurement stage device 30, measurement system 40, measurement chamber carrier system 62 and the like and measurement controller 50, structure a measurement section 65 (refer to FIG. 15) that performs pre-measurement with respect to the wafer before exposure held on shuttle 10.

Other than this, exposure system 1000 according to the embodiment is further equipped with a shuttle carrier system 70 (refer to FIG. 14) that moves within space SP described earlier and repeatedly performs carriage operation of the shuttle; carrying shuttle 10 holding a wafer before exposure from measurement chamber 60 to load lock chamber 302 that each of the vacuum chambers 300ᵢ is equipped with, and carrying shuttle 10 holding a wafer that has been exposed from load lock chamber 302 to measurement chamber 60. Shuttle carrier system 70 is structured, for example, by a horizontal articulated robot which is movable within space SP. Shuttle carrier system 70 is controlled by a carrier system controller 72 (refer to FIG. 14) that includes a microcomputer and the like.

FIG. 14 shows a block diagram of a structure of a control system of exposure system 1000. The control system of exposure system 1000 is equipped with a main controller 100 consisting of a workstation or the like that has overall control over the whole exposure system 1000, measurement controller 50 which operates under the control of main controller 100, five exposure controllers 380₂ to 380₆, and carrier system controller 72.

FIG. 15 shows a block diagram of an input/output relation of measurement controller 50 structuring the control system in FIG. 14. Measurement controller 50 includes a microcomputer and the like, and controls each section shown in FIG. 15 provided within measurement chamber 60.

FIG. 16 shows a block diagram of an input/output relation of the five exposure controllers 380ᵢ (i=2 to 6) structuring the control system in FIG. 14. Measurement controller 380ᵢ includes a microcomputer and the like, and controls each section shown in FIG. 16 provided within exposure chamber 301ᵢ.

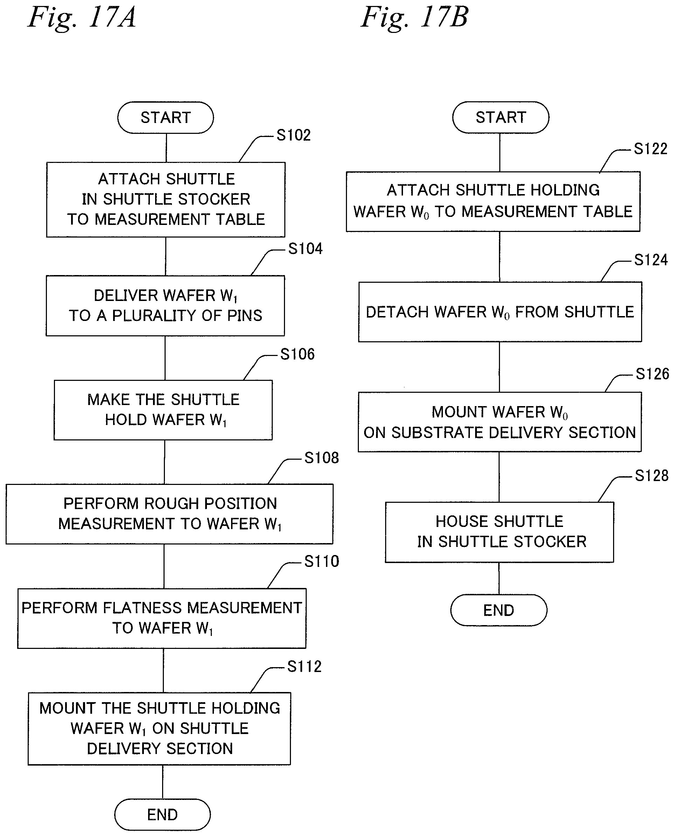

Next, an example of a preparatory operation performed within measurement chamber 60 will be described, based on a flowchart in FIG. 17A. The processing in each step described below is performed under the control of measurement controller 50; however, in the description below, for the sake of simplicity, description on measurement controller50 will be omitted except when necessary.

As a premise, a plurality of shuttles 10 is to be stored in the shuttle stocker (not shown). Also, the wafer before exposure is to be mounted on a substrate delivery section by a wafer carrier system at the C/D 9000 side which is connected in-line with measurement chamber 60.

In step S102, shuttle 10 stored in the shuttle stocker (not shown) is attached to measurement table TB. Specifically, shuttle 10 stored in the shuttle stocker (not shown) is carried from the shuttle stocker by measurement chamber carrier system 62 to an area above measurement table TB, which is positioned at the second position described earlier on measurement stage ST located at a wafer exchange position, and after this carriage, shuttle 10 is moved downward to be attached to measurement table TB via kinematic coupling.

In the next step S104, the wafer before exposure (wafer W₁ for convenience) at the substrate delivery section is delivered to the plurality of pins 32 of measurement stage ST by measurement chamber carrier system 62. On this operation, measurement table TB is at the second position and in this state, wafer W₁ is mounted on the plurality of pins 32 in a state where rotational position displacement and center position displacement are adjusted.

In the next step S106, shuttle 10 is made to hold wafer W₁. Specifically, by driving measurement table TB upward to the first position, wafer W₁ is mounted on the electrostatic chuck of shuttle 10, and then suction of the wafer by the electrostatic chuck is started. Note that a connection terminal connected to the electrostatic chuck is provided at shuttle 10, and a table side terminal connected to an electric power supply source (not shown) is provided at measurement table TB, and when shuttle 10 is attached to measurement table TB via kinematic coupling, the connection terminal and the table side terminal are connected, which allows electric power to be supplied to the electrostatic chuck from the electric power supply source.

In the next step S108, an approximate (rough) position measurement of wafer W₁ with respect to shuttle 10 is performed. Specifically, first of all, after search alignment of wafer W₁ is performed, position information of a reference mark (not shown) provided in shuttle 10 is measured to obtain relative position information of wafer W₁ with respect to shuttle 10 (reference mark).

On search alignment, for example, at least two search alignment marks (hereinafter referred to as search marks) positioned in the periphery of the center of wafer W₁ almost symmetrically are subject to detection. Measurement controller 50 controls the movement of measurement stage ST by measurement stage drive system 36 and acquires measurement information by measurement stage interferometer 38 while positioning each of the search marks within the detection area (detection field) of alignment detection system ALG, and based on detection signals when detecting the search marks formed on wafer W₁ using alignment detection system ALG and the measurement information by measurement stage interferometer 38, obtains position information of each of the search marks.

More specifically, measurement controller 50 obtains position coordinates on a reference coordinate system of the two search marks, based on detection results (relative positional relation between a detection center (index center) of alignment detection system ALG acquired from the detection signals and each search mark) of alignment detection system ALG output from the signal processor (not shown) and measurement values of measurement stage interferometer 38 at the time of each search mark detection. Here, the reference coordinate system is an orthogonal coordinate system set by the measurement axes of measurement stage interferometer 38.

Thereafter, measurement controller 50 obtains position coordinates on the reference coordinate system of a plurality of reference marks provided on shuttle 10 in a procedure similar to the search marks. Then, based on the position coordinates of the two search marks and the position coordinates of the plurality of reference marks, relative position of wafer W₁ with respect to shuttle 10 is obtained. The reason of calling this approximate position measurement is because detection accuracy of position coordinates of the marks by alignment detection system ALG is lower than detection accuracy of the position coordinates of the alignment marks detected by the reflected electrons performed right before exposure. This completes the approximate position measurement of wafer W₁ with respect to shuttle 10. Note that since wafer W₁ is actually loaded on shuttle 10 in a state where rotational position displacement and center position displacement are adjusted, the center position displacement of wafer W₁ is small enough to be ignored and the residual rotation error is extremely small.

When approximate position measurement of wafer W₁ with respect to shuttle 10 is completed in step S108, the operation proceeds to step S110, and flatness measurement (measurement of unevenness of the surface) of wafer W₁ is performed. This flatness measurement is performed by taking in measurement information of surface position detection device AF and the measurement information of measurement stage interferometer 38 at a predetermined sampling spacing, while moving measurement stage ST in the Y-axis direction. Here, the flatness measurement of the wafer is performed because in the electron beam exposure apparatus, position measurement error (lateral displacement) of the wafer within the XY plane occurs due to unevenness of the wafer surface, therefore, the position measurement error has to be corrected on exposure. This position measurement error can be obtained easily through calculation based on flatness information (Z position information Z (X, Y) corresponding to XY coordinate positions (X, Y) on a wafer coordinate system) of the wafer. Note that since the information of rotational displacement of the wafer is known by search alignment, the relation between the wafer coordinate system and the reference coordinate system described earlier can be obtained easily.

When flatness measurement in step S110 is completed, in step S112, shuttle 10 holding wafer W₁ is moved upward by measurement chamber carrier system 62 so that the kinematic coupling is released, and after being detached from measurement table TB, shuttle 10 is mounted on a shuttle mounting section at a loading side of a shuttle delivery section provided at the border with space SP of measurement chamber 60. This completes the preparatory operation including pre-measurement operation (S108, S110) within measurement chamber 60. Note that the electrostatic chuck of shuttle 10 can hold wafer W₁ by residual charge after shuttle 10 has been detached from measurement table TB. Also, an internal power supply can be provided in shuttle 10, and electric power may be supplied to the electrostatic chuck from this internal power supply after shuttle 10 has been detached from measurement table TB.

Next, an unloading operation of the wafer that has been exposed performed within measurement chamber 60 will be described, based on a flowchart in FIG. 17B. The processing in each step described below is performed under the control of measurement controller 50; however, in the description below, for the sake of simplicity, description on measurement controller 50 will be omitted except when necessary. As a premise, the shuttle holding the wafer that has been exposed is to be mounted on a shuttle mounting section at an unloading side of the shuttle delivery section.

In step S122, shuttle 10 holding the wafer that has been exposed (to be described as wafer W₀ for convenience) is attached to measurement table TB. Specifically, shuttle 10 holding wafer W₀ is carried from shuttle mounting section at the unloading side of the shuttle delivery section by measurement chamber carrier system 62 to an area above measurement table TB, which is positioned at the first position described earlier on measurement stage ST located at the wafer exchange position, and after this carriage, shuttle 10 is moved downward to be attached to measurement table TB via kinematic coupling.

In the next step S124, wafer W₀ is detached (removed) from shuttle 10. Specifically, suction of wafer W₀ by the electrostatic chuck of shuttle 10 is released, and measurement table TB is moved downward to the second position. By this operation, wafer W₀ is pushed upward as a whole from below by the plurality of pins 32, which allows wafer W₀ to be detached easily from shuttle 10. Note that in the case it is difficult to detach wafer W₀ from shuttle 10 due to residual charge, an ultrasonic wave may be applied to wafer W₀, or the wafer may be detached while performing various neutralizing measures.

In the next step S126, wafer W₀ supported by the plurality of pins 32 is carried from measurement table TB by measurement chamber carrier system 62 and is mounted on the substrate delivery section described earlier.

In the next step S128, shuttle 10 is moved upward by measurement chamber carrier system 62 so that the kinematic coupling is released, and after being detached from measurement table TB, shuttle 10 is housed on an empty shelf in the shuttle stocker. This completes the unloading operation of the wafer that has been exposed performed within measurement chamber 60. Shuttle 10 housed inside the shuttle stocker is stored within the shuttle stocker, and is adjusted (cooled) to a predetermined temperature during this storage until it is taken out next.

Next, a flow of processing with respect to a wafer by exposure system 1000 will be described. The processing described below is performed by measurement controller 50, exposure controllers 380₂ to 380₆, and carrier system controller 72 under the control of main controller 100 that has overall control over these controllers, however, in the description below, description on these controllers will be omitted except when necessary. Also, inside each of the exposure chambers 301ᵢ, while two each of exposure units 310 are actually housed and two load lock chambers 302 (load lock chambers) are provided corresponding to the exposure units, in the description below, for convenience of explanation, one exposure unit 310 is housed in each of the exposure chambers 301ᵢ and only one load lock chamber is to be provided in the vacuum chamber. That is, the vacuum chamber (exposure chamber), the exposure unit, and the load lock chamber (load lock chamber) have a one to one correspondence with one another.

Prior to beginning the processing by exposure system1000, the wafer before exposure coated with the electron beam resist is mounted on the substrate delivery section provided at a border of measurement chamber 60 and C/D 9000 by the carrier system (e.g. an articulated robot) within C/D 9000. Inside C/D 9000, a series of processing including coating of the electron beam resist to a wafer is sequentially performed, and the wafer is sequentially mounted on the substrate delivery section.

First of all, processing in steps S102 to S112 described earlier is performed in measurement chamber 60. By this operation, shuttle 10 holding wafer W₁ before exposure on which approximate position measurement of the wafer with respect to the shuttle and flatness measurement have been completed is to be mounted on the shuttle mounting section at the loading side of the shuttle delivery section.

Next, after shuttle carrier system 70 carries shuttle 10 holding wafer W₁ before exposure from the shuttle mounting section at the loading side of the shuttle delivery section to the front of load lock chamber 302 corresponding to exposure chamber 301ᵢ specified by main controller 100, shuttle 10 is exchanged with shuttle 10 holding wafer W that has been exposed located inside the specified exposure chamber 301ᵢ. In this case, when any of exposure chambers 301ᵢ have completed the exposure processing to the wafer at that point, main controller 100 specifies that exposure chamber 301ᵢ, and if none of the exposure chambers have completed the exposure processing, specifies the exposure chamber 301ᵢ which is expected to complete the exposure processing at the earliest timing. Here, as an example, exposure chamber 301ᵢ that is expected to complete the exposure processing at the earliest timing is to be specified.

In the description below, a shuttle exchange operation, that is, an exchange operation of the wafer integral with the shuttle is described specifically, based on drawings. First of all, shuttle 10 holding wafer W₁ carried from the shuttle mounting section at the loading side of the shuttle delivery section, as is shown in FIG. 18, is carried by shuttle carrier system 70 to a position in front (in this case, the -Y side) of load lock chamber 302 of vacuum chamber 300ᵢ where exposure chamber 301ᵢ is formed inside. At this point, exposure of wafer W₀ is being performed inside exposure chamber 301ᵢ. Note that in the description below, "shuttle holding wafer W₁" is to be described as "shuttle 10₁" for convenience, and "shuttle holding wafer W₀" is to be described as "shuttle 10₀". Also, together with this, illustration of wafers is omitted in FIGS. 19 to 27 used in the description below.

When exposure of wafer W₀ is completed, after an outer side (atmosphere side) gate valve 302b provided at load lock chamber 302 of vacuum chamber 300ᵢ is opened as is shown in FIG. 18 with the outlined arrow pointing downward, shuttle 10₁ is carried in to load lock chamber 304 by shuttle carrier system 70 as is shown in FIG. 19 with the black arrow. Next, after outer side (atmosphere side) gate valve 302b is closed as is shown in FIG. 19 with the outlined arrow pointing upward, evacuation inside load lock chamber 304 is started.

Shuttle carrier system 70, after carrying in shuttle 10₁ in to load lock chamber 304, engages in an operation of carrying in a shuttle holding the next wafer before exposure from the shuttle delivery section into another load lock chamber, or in an operation (hereinafter called another operation) such as carrying out a shuttle holding another wafer that has been exposed from another load lock chamber and carrying the shuttle to the shuttle delivery section.

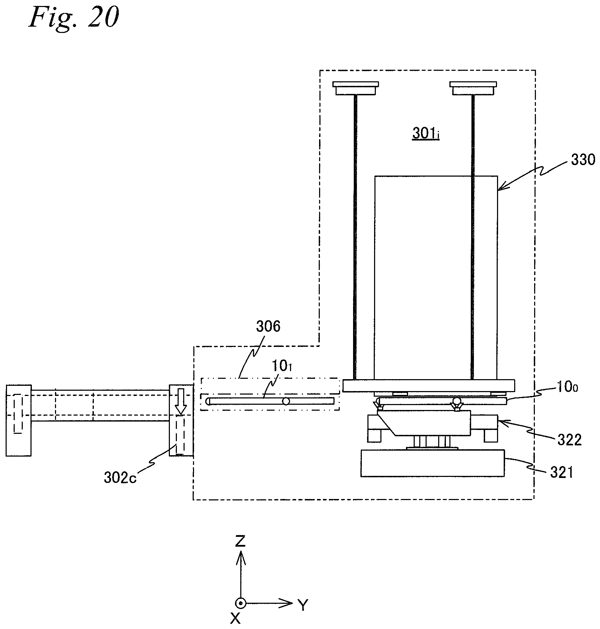

Then, when the inside of load lock chamber 304 reaches a high vacuum state about the same level as exposure chamber 301ᵢ, after an inner side (vacuum side) gate valve 302c provided at load lock chamber 302 is opened as is shown in FIG. 20 with the outlined arrow pointing downward, shuttle 10₁ is to be housed in exposure chamber carrier system 312 on the lower housing shelf of shuttle carrier 306 inside exposure chamber 301ᵢ. At this point, shuttle carrier 306 is in a first state (a first position) where the height of the lower housing shelf coincides with an opening of load lock chamber 304, as is shown in FIG. 20. The position of shuttle 10₁ at this point is to be referred to as a carry-in/carry-out position for convenience. At this point, exposure of wafer W₀ on shuttle 10₀ is being continued inside exposure chamber 301ᵢ. Note that in FIGS. 18 to 27, shuttle carrier 306 is shown simplified by a virtual line (two-dot chain line), to make the position of the shuttle easy to recognize.

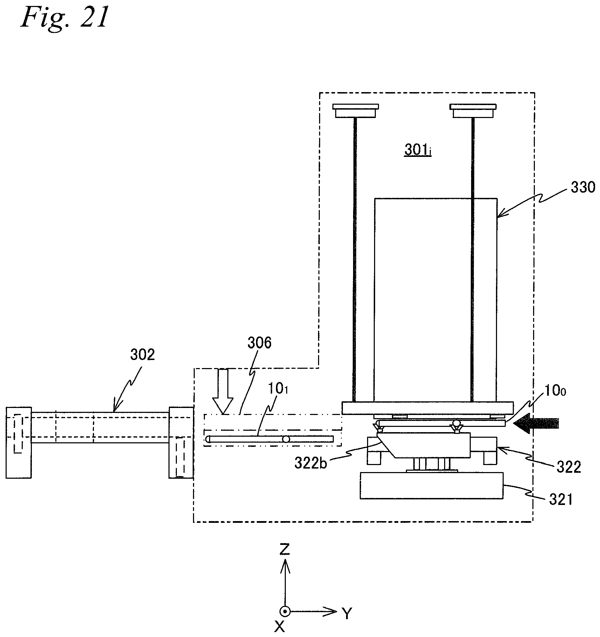

Then, shuttle carrier 306 is moved downward from the first position to a second position below the first position by a first distance as is shown in FIG. 21 with the outlined arrow. This moves shuttle carrier 306 into a second state where the height of the upper housing shelf coincides with the opening of load lock chamber 304. At this point, because exposure of wafer W₀ on shuttle 10₀ is being continued, shuttle carrier 306 maintains the second state until the exposure is completed. That is, shuttle 10₁ is waiting at a first waiting position below the carry-in/carry-out position.

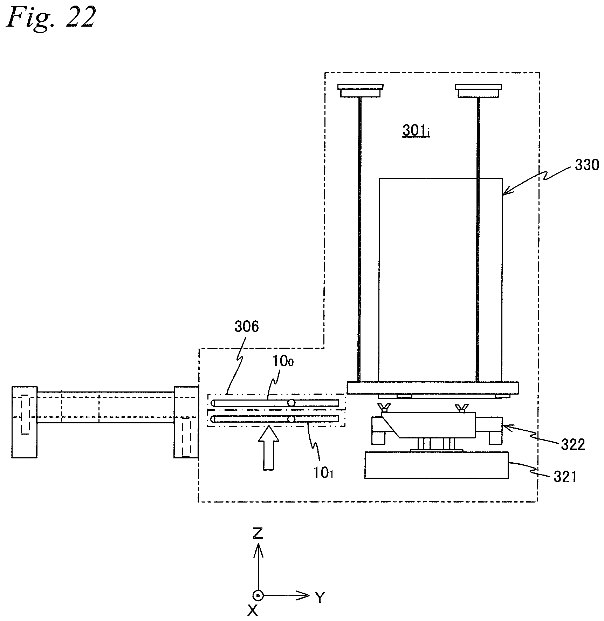

Then, when exposure is completed, shuttle 10₀ is detached from fine movement stage 322b and is carried toward the load lock chamber 302 side (-Y side) by exposure chamber carrier system 312 as is shown in FIG.21 with the black arrow, and is housed on the upper shelf of shuttle carrier 306. This makes a state where shuttle 10₀ and shuttle 10₁ respectively housed in the upper and lower shelves of shuttle carrier 306 are vertically arranged, as is shown in FIG. 22. Note that prior to shuttle 100 being detached from fine movement stage 322b, feedback control of the position and attitude of fine movement stage 322b in directions of six degrees of freedom is started by exposure controller 380ᵢ based on measurement information of the second measurement system 25 (refer to FIG. 16), which allows the position and attitude of fine movement stage 322b in directions of six degrees of freedom to be maintained to a predetermined state until position control of fine movement stage 322b integral with the shuttle based on measurement information of the first measurement system 20 (refer to FIG. 16) is started next.

Then, shuttle carrier 306 is moved upward by a first distance and returns to the first state (the first position) described earlier, as is shown in FIG.22 with the outlined arrow. That is, by this operation of moving shuttle carrier 306 upward, shuttle 10₁ and shuttle 10₀ are moved upward by the first distance so that shuttle 10₀ is to be positioned to a second waiting position above the carry-in/carry-out position of shuttle 10₀ and shuttle 10₁ is to be positioned to the carry-in/carry-out position.

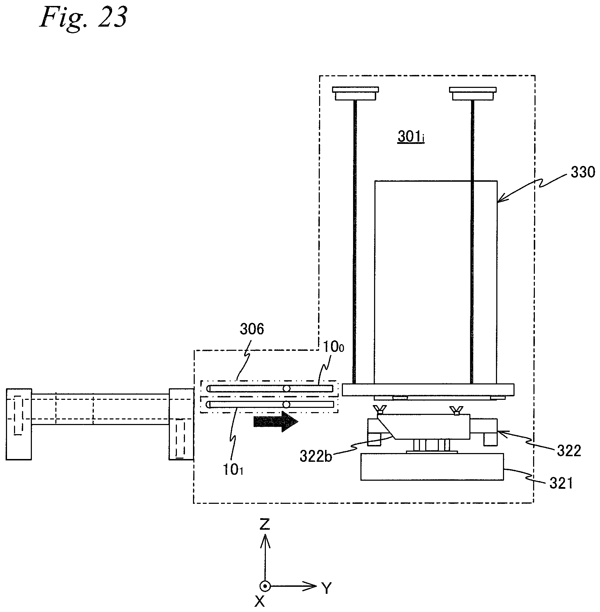

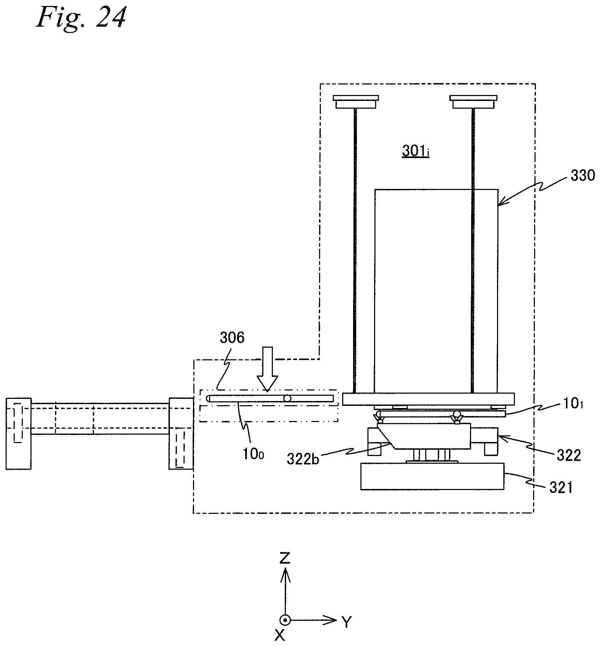

Next, shuttle 10₁ is taken out from shuttle carrier 306 by exposure chamber carrier system 312, and is carried toward an area above coarse/fine movement stage 322 as is shown in FIG. 23 with the black arrow, and is attached to fine movement stage 322b (refer to FIG. 24). On this operation, since the position and attitude of fine movement stage 322b in directions of six degrees of freedom to be maintained to a reference state as is previously described, positional relation between electron beam irradiation device 330 (electron beam optical system) and shuttle 10₁ becomes a desired positional relation only by attaching shuttle 10₁ to fine movement stage 322b via kinematic coupling. Then, by finely adjusting the position of fine movement stage 322b taking into consideration the results of approximate position measurement described earlier, it becomes possible to irradiate at least one each of alignment marks formed on a scribe line (street line) corresponding to each of the plurality of shot areas (e.g. 100) formed on wafer W₁ on shuttle 10₁ attached to fine movement stage 322b with an electron beam from the electron beam optical system without fail. Accordingly, a reflected electron of the at least one each of alignment marks is detected by a reflected electron detection system and alignment measurement of all points on wafer W₁ is performed, and based on the alignment measurement of all points, exposure with respect to the plurality of shot areas on wafer W₁ is started using electron beam irradiation device 330.

Concurrently with the alignment measurement of all points and the exposure described above, carriage operation (shuttle collecting operation) of shuttle 10₀ to the shuttle mounting section at the unloading side of the shuttle delivery section described earlier is performed in the following order.

That is, first of all, shuttle carrier 306 is moved downward by the first distance to be in the second state again, as is shown in FIG. 24 with the outlined arrow. With this operation, the upper housing shelf of shuttle carrier 306 in which shuttle 10₀ is housed is positioned at the same height as the opening of load lock chamber 304.

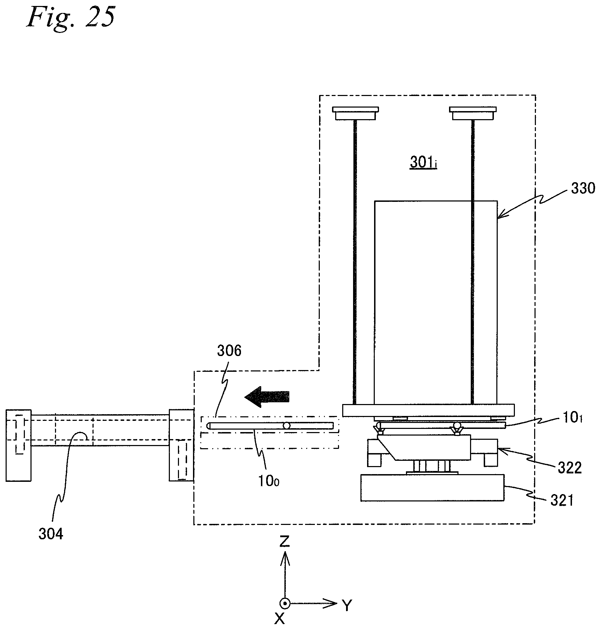

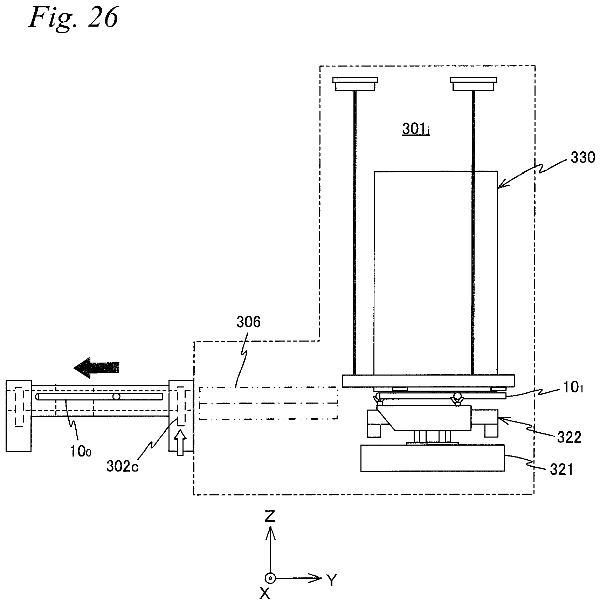

Next, shuttle 10₀ is taken out from shuttle carrier 306 by exposure chamber carrier system 312 and is carried toward load lock chamber 304 as is shown in FIG. 25 with the black arrow, and gate valve 302c at the vacuum side is closed (refer to the outlined arrow in FIG. 26) at the point when shuttle 10₀ is carried into load lock chamber 304.

At this point, shuttle carrier system 70 has temporarily ended the another operation described earlier, and is moved to the front of load lock chamber 302 that vacuum chamber 300ᵢ is equipped with. Note that in the case shuttle carrier system 70 is still performing the another operation, for example at the point when exposure of wafer W₀ in exposure chamber 301ᵢ has been completed, main controller 100 immediately stops the another operation and may move shuttle carrier system 70 to the front of load lock chamber 302 that vacuum chamber 300ᵢ is equipped with.

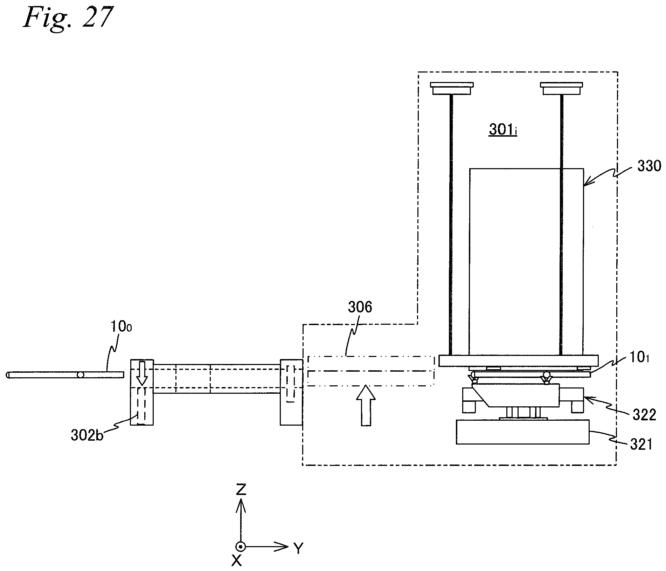

Then, after gate valve 302b at the atmosphere side is opened as is shown in FIG. 27 with the outlined arrow pointing downward, shuttle 10₀ is taken out from load lock chamber 304 by shuttle carrier system 70 and is collected. Exposure controller 380ᵢ, before or after opening gate valve 302b, moves shuttle carrier 306 in the second state upward by the first distance to restore shuttle carrier 306 to the first state, as is shown in FIG. 27 with the outlined arrow pointing upward. Note that gate valve 302b is closed after shuttle 10₀ is taken out.

Then, shuttle 10₀ that has been collected is returned immediately by shuttle carrier system 70 to the shuttle mounting section at the unloading side of the shuttle delivery section. Shuttle 10₀ that has been returned is carried toward measurement table TB for wafer exchange by measurement chamber carrier system 62. Hereinafter, the processing described earlier is repeatedly performed in measurement chamber 60, and each time main controller 100 specifies the exposure chamber, shuttle carriage by shuttle carrier system 70 and shuttle exchange and exposure processing operation are repeatedly performed in the specified exposure chamber 301ᵢ.

Note that while shuttle carrier 306 was restored to the first state (the first position) before or after the opening of gate valve 302 to take out shuttle 100 from load lock chamber 304, the embodiment is not limited to this, and shuttle carrier 306 may be left in the second state. In this case, on shuttle exchange inside exposure chamber 301ᵢ, shuttle exchange should be performed in a procedure similar to the procedure described above while employing an opposite setting of the first state and the second state of shuttle carrier 306 from the description above. In this case, the first waiting position with respect to the shuttle holding the wafer before exposure is to be set above the carry-in/carry-out position, and the second waiting position with respect to the shuttle holding the wafer that has been exposed is to be set below the carry-in/carry-out position.

Note that since the total time required for the preparatory operation in measurement chamber 60 described above and the series of operations (operations such as carry-in of the shuttle holding the wafer before exposure from the shuttle delivery section to the load lock chamber, carry-out of the shuttle holding the wafer that has been exposed from the load lock chamber, and carriage to the shuttle delivery section) by shuttle carrier system 70 is actually much shorter than the time required for the exposure operation (including alignment operation for all points) performed in one exposure unit 310, one each of measurement chamber 60 and shuttle carrier system 70 provided is enough for 10 exposure units 310, as in exposure system 1000 according to the embodiment. That is, the series of operations inside measurement chamber 60 and the series of operations by shuttle carrier system 70 do not cause throughput of the entire exposure system 1000 to decrease. On the contrary, by providing only one each of a measurement chamber and a shuttle carrier system with respect to a plurality of exposure units as in exposure system 1000 according to the embodiment, this compensates for the disadvantage that throughput is extremely low which is an essential disadvantage of electron beam exposure and practically allows sufficient throughput to be secured. Note that since increasing the number of vacuum chambers (exposure chambers) is easy adjacent to at least either vacuum chamber 300₃ or vacuum chamber 300₆, in the case measurement chamber 60 and shuttle carrier system 70 have idle time, further increase in throughput can be expected by increasing the number of exposure chambers (and exposure units).

As is described so far, with exposure system 1000 according to the embodiment, the first control rack 200 that distributes utilities supplied via wiring and piping from under floor surface F to each of the chambers 300₁ to 300₆ is placed adjacent to the -X side with respect to chambers 300₄ to 300₆ which are lined on the -Y side, and also placed on the -Y side facing C/D 9000. Therefore, a layout becomes possible in which footprint (especially the width dimension (dimension the Y-axis direction)) of the side of two rows of chambers 300₁ to 300₃ and 300₄ to 300₆ and the side of C/D 9000 are arranged evenly, and although the exposure chambers are arranged in two rows at one side in the longitudinal direction of C/D 9000, no empty space with low usability is made at one side in a direction orthogonal to the longitudinal direction of C/D 9000.

Also, component parts of exposure system 1000 including the two rows of chambers, the first control rack 200, and the second control rack 500 occupy a rectangular parallelepiped space as a whole, along with C/D 9000. Accordingly, in the embodiment, it becomes possible to avoid space with low usability being made within the clean room and to improve the use efficiency of space.

Also, utilities being supplied from above to each of the chambers 300₁ to 300₆ by the second control rack 500 has the following advantage. That is, for example, while many wires (wiring) have to be connected to barrel 330 of electron beam irradiation device330, when such wires are connected from below, for example, stage device320 including coarse/fine movement stage 332 existing become an obstacle, making connection itself be difficult. On the other hand, in the case of performing wire connection to barrel 331 from above, since there are no obstacles, connection is easy even when there are many wires.

Also, exposure system 1000 according to the embodiment is equipped with two each of exposure units housed inside vacuum chambers 300₂ to 300₆ that is a total of 10 exposure units 310, and each exposure unit 310 is equipped with electron beam irradiation device 330 that has, e.g. 100 optical system columns each consisting of a multi-beam optical system that can each be turned on/off, is deflectable, and can arrange circular spots of, e.g. 4000 electron beams of a 20nm diameter in a rectangular (e.g. 100 µm × 20 nm) exposure area, arranged inside barrel 331 corresponding in an almost one to one positional relation to, e.g. 100 shot areas on, e.g. a 300 mm wafer. Accordingly, by performing exposure on different wafers concurrently with the total of 10 exposure units 310, throughput can be improved greatly when compared to the conventional electron beam exposure apparatus.

Also, with exposure system 1000 according to the embodiment, pre-measurement such as measurement of positional relation of the wafer with respect to the shuttle and flatness measurement of the wafer are performed in a state holding the wafer with shuttle 10 prior to exposure in measurement chamber 60 separate from exposure chamber 301ᵢ, and then shuttle 10 holding the wafer on which the pre-measurement has been completed is carried into each of the exposure chambers 301ᵢ, and only by attaching the shuttle to fine movement stage 332b at the reference position via kinematic coupling, alignment measurement and exposure of the wafer can be started immediately. In this point as well, throughput can be improved compared to the conventional exposure apparatus.

Also, with exposure system 1000, the wafer that has completed pre-measurement and the wafer that has completed exposure are carried by shuttle carrier system 70 integrally with shuttle 10 between measurement chamber 60 and each of the load lock chambers 302 of vacuum chambers 300₂ to 300₆. Therefore, after exposure chamber carrier system 312 carries shuttle 10 holding the wafer on which pre-measurement has been completed that has been carried into each of the load lock chambers 302 of vacuum chambers 300₂ to 300₆ into each of the exposure chambers 301ᵢ and attaches the shuttle to fine movement stage 322b, fine alignment of the wafer and exposure of the wafer based on the alignment results can be started immediately.

Also, according to the embodiment, exchange of wafer inside exposure chamber 301ᵢ is performed integral with the shuttle in a procedure like the one described based on FIGS. 18 to 27, and especially a procedure (refer to FIGS. 22 and 23) is employed in which by housing shuttle 10₁ holding wafer W₁ before exposure and shuttle 10₀ holding wafer W₀ that has been exposed on the lower and upper shelves of shuttle carrier 306, respectively, both shuttles 10₀ and 10₁ are vertically arranged, and by moving shuttle carrier 306 upward (or downward), both shuttles 10₀ and 10₁ are moved upward simultaneously. Therefore, exchange of wafer integral with the shuttle can be performed using space of exposure chamber 301ᵢ effectively, and volume (dimension in the X-axis direction and the Y-axis direction) inside exposure chamber 301ᵢ does not have to be increased more than necessary. In this point, it becomes possible to reduce footprint. Note that in the embodiment, while shuttle carrier 306 was used to move both shuttles 10₀ and 10₁ upward (or downward) simultaneously in a state where both shuttles were vertically arranged, shuttle carrier 306 does not necessarily have to be used, and if a similar operation can be performed, then the structure will not matter in particular. For example, both shuttles 10₀ and 10₁ may be moved upward (or downward) simultaneously in a state where both shuttles are vertically arranged by a robot.

Also, with stage device 320 equipped in each of the plurality of exposure units 310 of exposure system 1000 according to the embodiment, since coarse movement stage drive system 323 that moves coarse movement stage 332a in the X-axis direction is structured employing a uniaxial drive mechanism such as a feed screw mechanism using a ball screw, there is no risk of magnetic flux leakage from the feed screw mechanism. Also, since closed magnetic field type and a moving magnet type motor 327 described earlier is used as fine movement stage drive system 327 that moves fine movement stage 332b to which shuttle 10 is attached in directions of six degrees of freedom, and the upper surface and both side surfaces of the motor is covered with shield member 328 that has both ends fixed to coarse movement stage 332a, it is possible to effectively suppress or prevent magnetic flux from leaking upward in the entire movement range of coarse movement stage 332a and fine movement stage 332b. Accordingly, in the embodiment, there is no risk of variation of magnetic field which cannot be ignored occurring that has an adverse effect on positioning of electron beams emitted from the beam source of electron beam irradiation device 330. Note that stage device 320 according to the embodiment is suitable as a stage device used in an electron beam exposure apparatus, other charged particle beam exposure apparatuses, SEM and the like, since the device effectively suppresses or prevents magnetic flux from leaking upward as is described above.

Note that in the embodiment, while an example was given as coarse movement stage drive system 323 of a structure employing a feed screw mechanism using a ball screw, the structure is not limited to this. For example, it is also possible to use a coarse movement stage drive system to which countermeasures for magnetic flux leakage are applied, similar to the fine movement stage as the coarse movement stage drive system.

Also, with stage device 320 according to the embodiment, since weight canceling device 324 is provided that supports the self-weight of fine movement stage 332b (and shuttle 10) on surface plate 321, a steady force to support the self-weight when fine movement stage (and shuttle 10) are not moved has to be generated by motor 327. This can prevent inconvenience that may occur when heat generation increases, and can further suppress or prevent magnetic force from having an adverse effect on positioning of electron beams.

Also, with exposure unit 310 according to the embodiment, in the state where shuttle 10 is attached to fine movement stage 322b, position information of fine movement stage 322b in directions of six degrees of freedom is measured by the first measurement system20 consisting of the encoder system described earlier that measures position information of shuttle 10. Since the optical path length of the measurement beam of the encoder system is much shorter than the interferometer, the encoder system only requires a small space, which allows the size of the first measurement system 20 to be reduced. Also, the first measurement system 20 as is described earlier can perform measurement in a total of twelve degrees of freedom, and measurement is performed redundantly for each of the directions of six degrees of freedom so that two each of position information is obtained. Then, exposure controller 380, based on position information measured by the first measurement system 20, uses an average value of the two each of position information for each degree of freedom as the measurement result for each direction. This makes it possible to obtain position information of shuttle 10 and fine movement stage 322b with high precision for all directions of six degrees of freedom by the averaging effect. Accordingly, position controllability of the wafer on exposure can be improved, which allows exposure with high precision.

Note that with exposure unit 310 according to the embodiment, since position controllability of the wafer on exposure can be improved, exposure unit 310 can be suitably used for removing a part of a line pattern and forming a pattern including an aperiodic part finer than the resolution limit of the ultraviolet ray exposure apparatus. Here, as such pattern forming method, as is disclosed in, for example, Japanese Unexamined Patent Application Publication No. 2011-258842, as a first step, a line-and-space pattern having a line width d (a line width finer than the resolution limit of an ultraviolet ray exposure apparatus) and a pitch 2d is formed by a double patterning method on each shot area on the wafer. Then, as a second step of the pattern forming method and the like, in each shot area, line patterns are partially removed from the line-and-space pattern by exposure using the electron beam exposure apparatus and etching.

In the case of performing the patterning method described above using exposure system 1000, in the first step, for example, after forming a line-and-space pattern, for example, having a 10 nm line width and a 20 nm pitch in each shot area on the wafer by the double patterning method, in the second step, by performing exposure of the aperiodic part using each exposure unit 310 of exposure system 1000 with the wafer serving as a target, a circuit pattern including the aperiodic part (separating section) finer than the resolution limit of the ultraviolet ray exposure apparatus can be effectively formed.

Note that the double patterning method used in the first step may be either pitch split (Pitch Splitting) technology or spacer pitch doubling technology (Spacer Pitch Doubling, Spacer transfer or Sidewall transfer) technology. Also, the target used in the second step is not limited to the wafer by the double patterning method, and may be a wafer having a line-and-space pattern with a line width d (a line width finer than the resolution limit of the ultraviolet ray exposure apparatus) and a pitch 2d in each shot area on the wafer formed using an electron beam exposure apparatus, an EUV exposure apparatus or the like.

Also, with exposure unit 310 according to the embodiment, the second measurement system 25 that constantly measures position information in directions of six degrees of freedom of fine movement stage 322b is provided separate from the first measurement system 20. Therefore, even when the shuttle is detached from fine movement stage 322b, exposure controller 380ᵢ (i=2 to 6) can control the position and attitude of fine movement stage 322b in directions of six degrees of freedom.

Also, with exposure system 1000 according to the embodiment, a pair of exposure units 310 is housed inside vacuum chamber 300ᵢ. That is, in each of vacuum chambers 300₂ to 300₆ inside, not only is stage device 320 housed that includes fine movement stage 322b that can be moved to which shuttle 10 holding wafer W is attached, but the entire electron beam irradiation device 330 is also housed, structuring exposure unit 310 together with stage device 320 and having an electron beam optical system which performs exposure irradiating the wafer held by shuttle 10 on fine movement stage 322b with an electron beam. Accordingly, even if the atmospheric pressure changes, barrel 331 entirely housed inside vacuum chamber 300ᵢ is not deformed, which eliminates the risk of a situation occurring where the electron beam optical system inside barrel 331 is adversely affected.

Note that in the embodiment above, while the case has been described where stage device 320 is equipped with magnetic shield member 328 that has both ends fixed to coarse movement stage 332a and weight canceling device 324 as a structure for suppressing or preventing magnetic field variation, for example, stage device 320 may be equipped only with magnetic shield member 328.

Note that in the embodiment above, while an example has been described where a pair of exposure units 310 is housed inside vacuum chamber 300ᵢ, the embodiment is not limited to this, and one exposure unit 310, or three or more exposure units may be housed in one vacuum chamber. Also, in the embodiment above, while the case has been described where exposure system 1000 is equipped with five exposure chambers 301ᵢ and one measurement chamber 60, at least one exposure chamber is enough. Also, while chamber 300₁ in which measurement chamber 60 is formed was a part of two rows of three chambers aligned, chamber 300₁ does not necessarily have to be a part of the two row chamber structure, and the place of installation does not matter. Also, not all of two rows of chambers 300₁ to 300₃ and 300₄ to 300₆ have to be arranged, and for example, only chamber 300₁ adjacent to C/D 9000 and chamber 300₄ adjacent to the first control rack 200 may be installed. Also, each section arranged inside measurement chamber 60 of the embodiment described above does not have to be provided inside chamber 300₁, and in short, any arrangement may be considered as long as measurement section 65 which allows pre-measurements such as approximate position measurement of the wafer with respect to the shuttle and flatness measurement is arranged as a part of the exposure system.

Also, content of the pre-measurement described above in the embodiment is a mere example, and other contents on measurement may also be included. Also, in the embodiment above, while the case has been described where measurement stage 30 on which the wafer before exposure is mounted for pre-measurement has loading/unloading devices(32, 34, TB) that perform loading of the wafer to shuttle 10 and unloading of the wafer from shuttle 10 together with measurement chamber carrier system 62 (carrier member), the embodiment is not limited to this, and a loading/unloading device which performs loading of the wafer to shuttle 10 and unloading of the wafer from shuttle 10 together with the carrier member of the measurement section may be provided separate from measurement stage ST used for pre-measurement. Also, a cleaning device for shuttle 10 may be provided inside the measurement section (measurement chamber 60 in the embodiment above).

Note that in the embodiment above, while the case has been described where the second control rack 500 was provided in addition to the first control rack 200, the second control rack 500 does not necessarily have to be provided. In the case the second control rack 500 is not provided, it is desirable for the first control rack 200 to distribute the utilities supplied from below floor surface F via wiring and piping to each of the chambers 300₁ to 300₆ from above.

Note that the number of chambers may be only chambers 300₁ and 300₂, and in this case, the second control rack 500 may be provided in an area above chambers 300₁ and 300₂.

### - First Modified Example

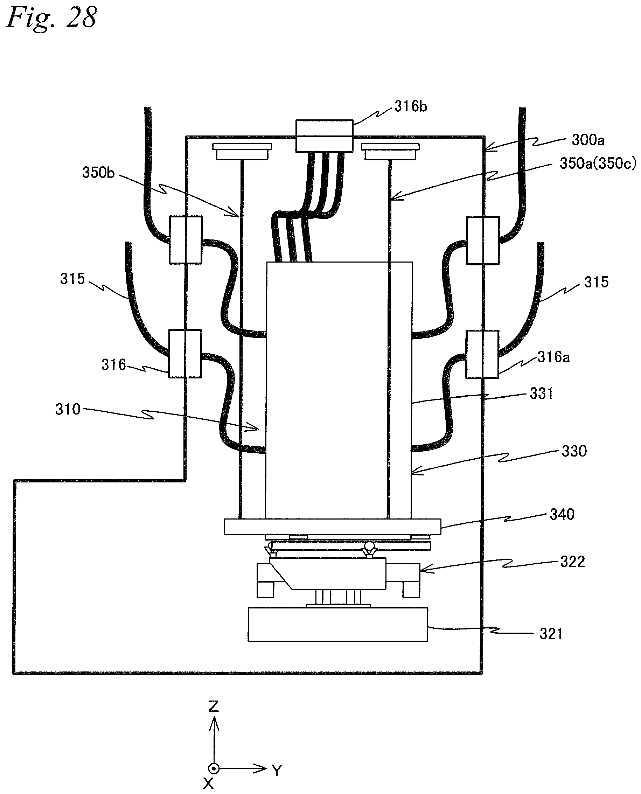

In the embodiment above, as is described earlier, the exposure system has been described where the second control rack 500 supplies utilities to vacuum chamber 300ᵢ from above. Next, a first modified example of this exposure system will be described, based on FIG. 28. FIG. 28 shows a vacuum chamber 300a equipped in the exposure system according to the modified example, and an exposure unit 310 housed therein. Vacuum chamber 300a corresponds to vacuum chamber 300ᵢ (i=2, 3, 4, 5, 6) described earlier. In the exposure system according to the modified example in FIG. 28, a part of a plurality of cables 315 serving as a supply member for supplying utilities and being connected to the inside of the second control rack 500 is connected to electron beam irradiation device 330 via a side wall of vacuum chamber 300a.

To the side wall of vacuum chamber 300a shown in FIG. 28, a plurality of mounting members (four in FIG. 28) 316a to which supply members such as wiring and piping are attached is provided, and in the ceiling wall of vacuum chamber 300a, at least one mounting member 316b is provided.

And to the outer periphery section and upper surface section of barrel 331 of electron beam irradiation device 330, one end of each of the plurality of cables 315 is connected via mounting member 316a or 316b. Each of the plurality of cables 315 includes at least one of wiring and piping. The other end of each of the plurality of cables 315 is connected to the second control rack 500 described earlier. Through these cables 315, utilities are supplied from the second control rack 500 located above vacuum chamber 300 to electron beam irradiation device 330.

Note that mounting members 316a and 316b support the middle section or one end of each of the plurality of cables 315 via a seal member to maintain air tightness inside vacuum chamber 300a.

Mounting members 316a and 316b may be structured by a kind of seal member that has a through hole which cable 315 penetrates is formed, or may be a vacuum connector that has a first member arranged on an inner surface side of vacuum chamber 300a and a second member arranged on an outer surface side of vacuum chamber 300a and connects the part in the chamber (the part located inside vacuum chamber 300a) and the part outside of the chamber (the part located outside vacuum chamber 300a) of each of the cables 315 and also maintains the air tightness inside vacuum chamber 300a.

### - Second Modified Example

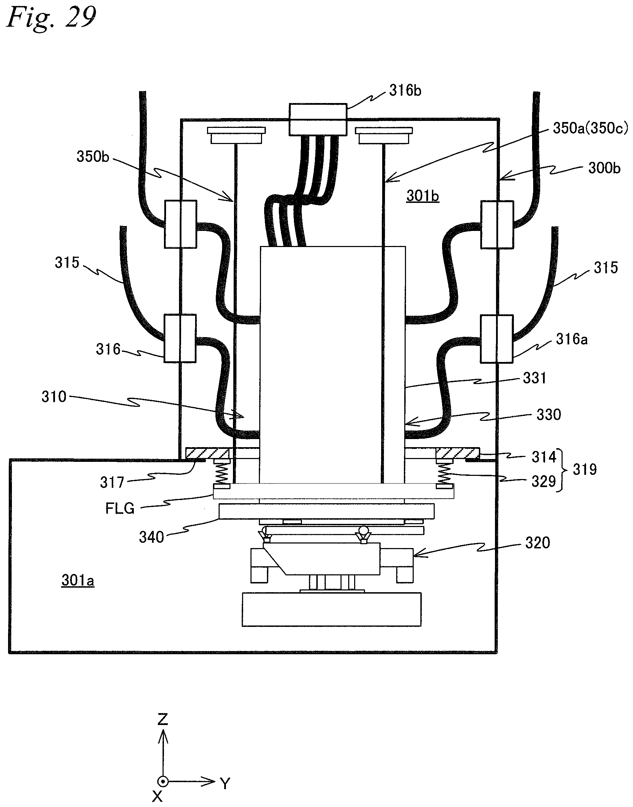

Next, an exposure system according to a second modified example will be described, based on FIG.29. FIG. 29 shows a vacuum chamber 300b equipped in the exposure system according to the second modified example, and an exposure unit 310 housed therein. Vacuum chamber 300b corresponds to vacuum chamber 300ᵢ (i=2, 3, 4, 5, 6) described earlier. The inner space of vacuum chamber 300b is divided into a first chamber 301a in which stage device 320 and an emitting end section (lower end section) of electron beam irradiation device 330 are housed, and a second chamber 301b in which the part excluding the lower end section of electron beam irradiation device 330 is housed. The exposure system according to the modified example uses vacuum chamber 300b instead of vacuum chamber 300ᵢ and employs the following structure to divide the inner space of vacuum chamber 300b into the first chamber 301a and the second chamber 301b, which are different from the embodiment described earlier. Note that in FIG. 29, illustration of the shuttle carrier and the exposure chamber carrier system is omitted.

To the side wall (side plate) and ceiling wall (ceiling plate) of the first chamber 301a part of vacuum chamber 300b, the plurality of cables 315 described earlier serving as supply members for supplying the utilities are attached (fixed) via mounting member 316a or 316b.

In the modified example, at the outer periphery section of barrel 331 of electron beam irradiation device 330, a flange section FLG is provided at a position further above metrology frame 340 described earlier, and via flange section FLG, electron beam irradiation device 330 is supported in a suspended state from the top plate (ceiling wall) of vacuum chamber 300b via the three suspension support mechanisms 350a, 350b, and 350c (connecting members having a flexible structure) described earlier. Flange section FLG is formed in a shape of a ring, protruding from the outer periphery section of barrel 331. Also, in order to maintain relative position between electron beam irradiation device 330 and vacuum chamber 300b to a predetermined state, at flange section FLG, a positioning device (not shown) of a non-contact method which is similar to positioning device 353 (refer to FIG. 16) described earlier is provided.

On an inner wall surface at a border between the first chamber 301a and the second chamber 301b of vacuum chamber 300b, a ring-shaped protruding section 317 is provided. And, between flange section FLG and protruding section 317, a ring-shaped connecting section 319 is provided that connects the flange section and the protruding section.

Ring-shaped connecting section 319 includes a ring-shaped plate 314 arranged on protruding section 317, and a ring-shaped metal bellows 329 arranged surrounding barrel 331 in between ring-shaped plate 314 and flange section FLG. Half the outer periphery side of the lower surface of ring-shaped plate 314 is mounted on the upper surface of protruding section 317 throughout the outer periphery. The upper end of bellows 329 is connected to the lower surface of ring-shaped plate 314 and the lower end is connected to the upper surface of flange section FLG. Therefore, bellows 329 is structured freely expandable in the Z-axis direction.

In the modified example, by protruding section 317, flange section FLG, and ring-shaped connecting section 319, the first chamber 301a and the second chamber 301b are divided having good airtightness.

Note that each of the lower end of the three suspension support mechanisms 350a, 350b, and 350c is connected to flange FLG via an opening in the center of ring-shaped plate 314.

In the modified example, since exposure unit 310 is housed inside vacuum chamber 300b similar to the embodiment described above, even if the atmospheric pressure changes, barrel 331 entirely housed inside vacuum chamber 300a is not deformed, which eliminates the risk of a situation occurring where the electron beam optical system inside barrel 331 is adversely affected. Adding to this, in the modified example, since no cables are arranged in the first chamber 301a, the first chamber 301a and the second chamber 301b are divided with good air tightness, and metal bellows 329 almost free of degassing is used for ring-shaped connecting section 319, each part arranged in the first chamber 301a is almost free from being affected by degassing.

Also, electron beam irradiation device 330 is supported in a suspended manner from the ceiling of vacuum chamber 300b by the three suspension support mechanisms 350a, 350b, and 350c, via flange section FLG. Also, flange section FLG is connected to ring-shaped plate 314 via metal bellows 329 which is freely expandable. Therefore, by the function of the three suspension support mechanisms 350a, 350b, and 350c, high vibration isolation performance can be obtained and weight of the mechanical section can be greatly reduced. Also, by the positioning device (not shown), the relative position of electron beam irradiation device 330 in the X-axis direction, the Y-axis direction, the Z-axis direction and relative rotation angle around the X-axis, the Y-axis, and the Z-axis with respect to vacuum chamber 300a is to be maintained at a constant state (a predetermined state). Also, ring-shaped connecting section 319 (bellows 329) allows relative displacement of flange section FLG (electron beam irradiation device 330 and metrology frame 340) with respect to vacuum chamber 300b, as well as prevents or effectively suppresses vibration transmission to flange section FLG (electron beam irradiation device 330 and metrology frame 340) from vacuum chamber 300b. Note that in the modified example, flange section FLG may also have the function of metrology frame 340, without metrology frame 340 being arranged separate from flange section FLG.

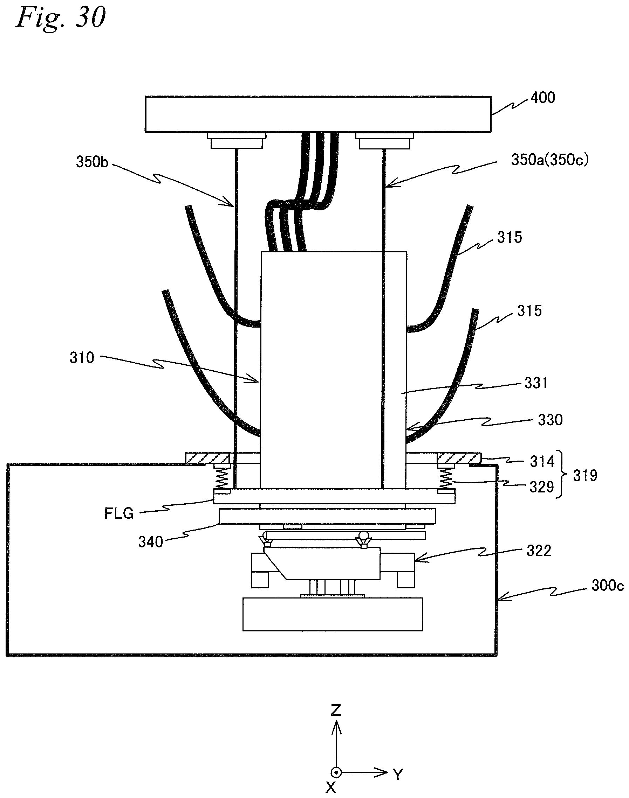

Note that in the embodiment above and the modified examples, while the case has been described where the entire exposure unit 310 is housed inside each of the vacuum chambers 300₂ to 300₆, 300a, and 300b, the embodiment and the modified examples are not limited to this, and for example, of exposure unit 310, the part exceeding the lower end of barrel 331 of electron beam irradiation device 330, that is, the upper end of barrel 331 may be exposed outside of vacuum chamber 300c, as is shown in FIG. 30. Vacuum chamber 300c shown in FIG. 30 consists only of the part corresponding to the first chamber 301a of vacuum chamber 300b in the second modified example described earlier. To secure the air tight state inside vacuum chamber 300c with respect to the outside, the inside and the outside of vacuum chamber 300c is divided by flange section FLG and ring-shaped connecting section 319 connected to the flange, similar to the modified example described earlier. Note that in the example in FIG. 30, electron beam irradiation device 330 is supported in a suspended manner from frame 400 described earlier by the three suspension support mechanisms 350a, 350b, and 350c, via flange section FLG. The example in FIG. 30 allows radiation of heat from electron beam irradiation device 330 through air. Note that also in this modified example in FIG. 30, flange section FLG may also have the function of metrology frame 340, without metrology frame 340 being arranged separate from flange section FLG.

Note that in the embodiment above and each of the modified examples, while electron beam irradiation device 330 was supported in a suspended manner integral with metrology frame 340 from the ceiling plate (ceiling wall) of the vacuum chamber or frame 400 via the three suspension support mechanisms 350a, 350b, and 350c, the embodiment and the modified examples are not limited to this, and electron beam irradiation device 330 may be supported by a floor type body.

Note that in the embodiment above, while the wafer before exposure and the wafer that has been exposed are carried between all vacuum chambers 300₂ to 300₆ and measurement chamber 60 integral with shuttle 10, the embodiment is not limited to this, and the wafer before exposure and the wafer that has been exposed may be carried alone between all vacuum chambers 300₂ to 300₆ and measurement chamber 60 by a wafer carrier system consisting of a horizontal articulated robot which moves along the moving route in space SP described earlier. In this case, to make exposure possible of the wafer not only on the first layer but also on the second layer and after, a device for performing pre-measurement of the wafer has to be arranged inside exposure chamber 301i so that electron beam irradiation device 330 can perform detection of alignment marks. In both cases of carrying the wafer integral with the shuttle and carrying the wafer alone, a structure may be employed where space SP described earlier in which the wafer is carried and a part of measurement chamber 60 that communicates with space SP can be set to a low vacuum state lower than the vacuum state inside the vacuum chamber. In the case of carrying the wafer (and shuttle) into the load lock chamber from the atmosphere, evacuation has to be performed until the inside of the load lock chamber moves into a high vacuum state around the same level as the inside of the vacuum chamber in the shortest time possible, and in this case, the environment that the wafer (and the shuttle) is placed changes from atmospheric pressure to high vacuum, and the temperature decline causes the wafer to contract. Meanwhile, in the case the wafer (and the shuttle) is carried into the load lock chamber from low vacuum space, the declining degree of temperature decreases, which reduces the contract of the wafer caused by the temperature decline.

Note that in the embodiment above, while the case has been described where the wafer was carried between measurement chamber 60 and each of the exposure chambers 301ᵢ integral with shuttle 10, the embodiment is not limited to this, and a holding member that has an electrostatic chuck similar to shuttle 10 may be mechanically fixed on fine movement stage 332b, and in an exposure apparatus that carries the wafer alone, the encoder system may measure position information of the holding member, for example, in directions of six degrees of freedom similar to the embodiment above. In this case, an encoder system similar to the first measurement system 20 in the embodiment described above may be used as the encoder system. In this case, since the holding member is not carried, a head section may be provided at the holding member side and a grating plate may be provided so that the head section can face the outside of the holding member.

Note that the shuttle holding the wafer that has been exposed does not have to be returned to measurement chamber 60. For example, a wafer carry-out section can be provided separate from measurement chamber 60, and the wafer can be taken out from the shuttle at this wafer carry-out section.

Also, in the embodiment above, while the case has been described where fine movement stage 332b can be moved in directions of six degrees of freedom with respect to coarse movement stage 332a, the embodiment is not limited to this, and the fine movement stage may be moved only in the XY plane. In this case, the first measurement system 20 and the second measurement system 25 that measure position information of the fine movement stage may be able to measure position information in directions of three degrees of freedom in the XY plane.

Also, in the embodiment above, while the case has been described where the first measurement system 20 performs redundant measurement for each direction of the directions of six degrees of freedom and obtains the position of the fine movement stage for each of the directions, based on an average of the two position information obtained for each of the directions, the embodiment is not limited to this, and redundant measurement may be performed further for each direction in directions of six degrees of freedom, and the position of the fine movement stage for each of the directions may be obtained based on an average of three or more position information. Or, redundant measurement may be performed only for a part of the directions, e.g. directions of three degrees of freedom in the XY plane, of directions of six degrees of freedom, or redundant measurement does not have to be performed on any of the directions.

Note that from another aspect, the embodiment above provides an exposure system that exposes a target coated with a sensitive agent with a charged particle beam, equipped with; a first chamber in which a measurement chamber is formed for performing pre-measurement on the target before exposure held by a first holding member, a second chamber in which an exposure chamber is formed for exposing the target held by a second holding member different from the first holding member with the charged particle beam, and a carrier system that after carrying the first holding member that holds the target on which pre-measurement has been completed from the first chamber into the second chamber via a load lock chamber, carries the second holding member holding the target that has been exposed from the vacuum chamber via the load lock chamber. In this case, the carrier system includes both the carrier system placed outside the vacuum chamber and the load lock chamber and the carrier system placed inside the vacuum chamber.

Also, further from another aspect, the embodiment above provides an exchange method of exchanging a target mounted on a table inside a vacuum chamber provided with a load lock chamber, the exchange method including; carrying a first holding member that holds the target before exposure into the load lock chamber, closing a gate valve at the atmosphere side of the load lock chamber and evacuating the inside of the load lock chamber, opening a gate valve at the vacuum side of the load lock chamber after the inside of the load lock chamber moves into a predetermined vacuum state to carry in the first holding member holding the target to a predetermined position inside the vacuum chamber, after carrying the first holding member to the predetermined position, moving the first holding member holding the target downward or upward by a predetermined distance to make the first holding member wait at a first waiting position, as well as carrying a second holding member holding the target that has been exposed from the table to the predetermined position, moving the first holding member and the second holding member upward or downward by a predetermined distance to make the second holding member be positioned at a second waiting position and to position the first holding member at the predetermined position, carrying in the first holding member at the predetermined position on the table and starting exposure on the target of the first holding member, positioning the second holding member waiting at the second waiting position to the predetermined position before or after the beginning of exposure, carrying in the second holding member at the predetermined position inside the load lock chamber and closing the gate valve at the vacuum side, and opening the gate valve at the atmosphere side of the load lock chamber and carrying the second holding member outside from the load lock chamber.

Also, further from another aspect, the embodiment above provides a first stage device equipped with a base member, a first stage that can be moved in a first direction with respect to the base member, a second stage that can be moved in a second direction intersecting the first direction with respect to the first stage, a drive motor for moving the second stage, and a magnetic shield member provided at the first stage that covers at least the upper surface and the side surface of the motor.

Also, further from another aspect, the embodiment above provides a second stage device equipped with a base member, a first stage that can be moved in a first direction with respect to the base member, a second stage that can be moved in a second direction intersecting the first direction with respect to the first stage, a drive motor for moving the second stage, a magnetic shield member that covers at least the upper surface and the side surface of the motor, and a weight canceling device that supports self-weight of the second stage on the base member.

Also, further from another aspect, the embodiment above provides a first exposure apparatus equipped with one of the first and the second stage devices with the second stage holding the target, and a charged particle beam irradiation device having a charged particle beam optical system that irradiates the target with a charged particle beam.

Also, further from another aspect, the embodiment above provides a second exposure apparatus equipped with; a charged particle beam irradiation device having a charged particle beam optical system that irradiates a charged particle beam on the target, a table that can be moved within a predetermined plane orthogonal to an optical axis of the charged particle beam optical system holding the target, a drive system that moves the table, an encoder system that can measure position information of the table, and a controller controls movement of the table by the drive system based on the position information measured by the encoder system.

Note that in the embodiment above, while the case has been described where the target is a wafer for manufacturing semiconductor devices, exposure system 100 according to the embodiment can also be suitably applied when manufacturing a mask by forming a fine pattern on a glass substrate. Also, in the embodiment above, while an electron beam exposure system 1000 has been described that uses an electron beam as a charged particle beam, the embodiment above can also be applied to an exposure system that uses an ion beam or the like as the charged particle beam for exposure.

### INDUSTRIAL APPLICABILITY

As is described so far, the exposure system according to the present invention is suitable for usage in a lithography process when manufacturing electronic devices such as semiconductor devices.

### REFERENCE SIGNS LIST

60...measurement chamber,
200...first control rack,
300₁, 300₂, 300₃...chamber,
300₄, 300₅, 300₆...chamber,
301ᵢ...exposure chamber,
302...load lock chamber,
310...exposure unit,
322...coarse/fine movement stage,
330...electron beam irradiation device,
350a, 350b, 350c...suspension support mechanism,
351...vibration isolation pad,
352...wire,
353...positioning device,
400...frame,
500...second control rack,
1000...exposure system,
9000...C/D,
F...floor surface,
SP...space,
W, W₀, W₁...wafer.

## Claims

1. An exposure system that exposes a target with a charged particle beam, comprising:
a first chamber arranged adjacent to a substrate processing device which coats a sensitive agent on a target;
a second chamber, with respect to the first chamber adjacent in a first direction with the substrate processing device, being arranged apart in a second direction intersecting the first direction; and
a first control rack that is arranged adjacent or in close proximity to each of the second chamber and the substrate processing device, and is connected to an external utility supply source, wherein
the first control rack distributes utilities supplied from the utility supply source to each of the first chamber and the second chamber.

2. The exposure system according to claim 1, further comprising:
a second control rack arranged above the first chamber and the second chamber that supplies the utilities supplied from the first control rack to the first chamber and the second chamber.

3. The exposure system according to one of claims 1 and 2, wherein
the second chamber and the first control rack are arranged adjacent in the first direction.

4. The exposure system according to any one of claims 1 to 3, wherein
the substrate processing device and the first chamber are connected in-line, and
space inside the substrate processing device, space in the first control rack, and space in the second chamber are independent of one another.

5. The exposure system according to claim 4, wherein
the substrate processing device, the first control rack, and the second chamber are distanced apart from one another.

6. The exposure system according to any one of claims 1 to 5, comprising:
a third chamber arranged in the first direction adjacent to an other side opposite to one side of the first chamber to which the substrate processing device is adjacent.

7. The exposure system according to any one of claims 1 to 6, comprising:
a fourth chamber arranged in the first direction adjacent to an other side opposite to one side of the second chamber to which the first control rack is adjacent.

8. The exposure system according to claim 7, comprising:
a carrier chamber arranged between the first chamber and the second chamber and between the third chamber and the fourth chamber that is connected to each of the first chamber, the second chamber, the third chamber, and the fourth chamber.

9. The exposure system according to claim 8, wherein
in the carrier chamber, a carrier space is formed to carry the target between the first chamber, and the second, the third, and the fourth chambers.

10. The exposure system according to claim 9, wherein
the carrier space and space inside the first chamber have an atmosphere different from space inside the second, the third, and the fourth chambers

11. The exposure system according to claim 10, wherein
the space inside the second, the third, and the fourth chambers is a vacuum atmosphere.

12. The exposure system according to claim 11, wherein
inside of the carrier chamber and inside of the first chamber can be set to a low vacuum state whose vacuum level is lower than the inside of the second, the third, and the fourth chambers.

13. The exposure system according to any one of claims 9 to 12, wherein
the exposure system has load lock chambers provided in between each of the first, the second, the third, and the fourth chambers and the carrier chamber.

14. The exposure system according to claim 13, wherein
a measurement chamber where measurement of the target is performed is formed inside the first chamber, and
inside the second, the third, and the fourth chamber, an exposure chamber where the target on which the sensitive agent is coated is exposed with a charged particle beam is formed.

15. The exposure system according to claim 14, wherein
in each of the second, the third, and the fourth chambers, at least one each of an exposure unit that exposes the target on which the sensitive agent is coated with the charged particle beam is partly or entirely housed.

16. The exposure system according to claim 15, wherein
in each of the second, the third, and the fourth chambers, two each of the exposure units is partly or entirely housed.

17. The exposure system according to one of claims 15 and 16, wherein
the exposure unit has a stage device including a stage that can move holding the target and a charged particle beam irradiation device that performs exposure by irradiating the target with a charged particle beam, and
the stage and at least the light-emitting section of the charged particle beam irradiation device are housed inside of the chamber.

18. The exposure system according to claim 17, wherein
the whole exposure unit is housed inside of the chamber.

19. The exposure system according to one of claims 17 and 18, wherein
the stage device includes an encoder system that measures position information of the stage, the encoder system having a grating section provided at one of the stage and outside of the stage on which a two-dimensional grating is formed and a head section provided at the other of the stage and outside of the stage being opposable to the grating section that irradiates a plurality of beams on the grating section and receives return beams from the grating section.

20. The exposure system according to claim 19, wherein
the exposure unit further has a metrology frame in which a component part of the encoder system provided outside of the stage of the grating section and the head section is provided, and
the metrology frame is supported integral with the charged particle beam irradiation device in a suspended manner from a ceiling section of the chamber via a plurality of flexible structured suspension support mechanisms.

21. The exposure system according to claim 20, wherein
the charged particle beam irradiation device is supported in a suspended manner at three points via three of the suspension support mechanisms at the ceiling section of the chamber, via the metrology frame.

22. The exposure system according to one of claims 20 and 21, wherein
the suspension support mechanism includes a vibration isolation pad fixed to the ceiling section, and a wire having one end connected to the vibration isolation pad and the other end connected to the support member of the charged particle beam irradiation device.

23. The exposure system according to claim 22, further comprising:
a positioning device of a non-contact method to maintain relative position of the charged particle beam irradiation device and the chamber to a predetermined state.

24. The exposure system according to any one of claims 1 to 23, wherein
the first chamber, the second chamber, the first control rack, and the second control rack occupy a rectangular solid space as a whole, along with the substrate processing device.

25. The exposure system according to any one of claims 1 to 24, wherein
the utility supply source is arranged below a floor surface where the substrate processing device, the first chamber, the second chamber, and the first control rack are arranged, and
a first supply member connected to the utility supply source via the floor surface is connected to the first control rack.

26. An exposure system that exposes a target on which a sensitive agent is coated with a charged particle beam, comprising:
an exposure unit that has a stage device including a stage that can move holding the target and a charged particle beam irradiation device that performs exposure by irradiating the target with a charged particle beam,
a vacuum chamber that houses at least a part of the exposure unit, and
a mounting member provided in at least one of a side wall and a ceiling wall of the vacuum chamber and to which a supply member that supplies utilities supplied from an external utility supply source to the charged particle beam irradiation device is attached.

27. The exposure system according to claim 26, wherein
the vacuum chamber has a first chamber in which the stage and a light-emitting section emitting the charged particle beam in the charged particle beam irradiation device is housed, and a second chamber in which parts excluding the light-emitting section is housed, and the mounting member is provided at the second chamber.

28. The exposure system according to claim 27, wherein
the charged particle beam irradiation device is supported in a suspended manner via a plurality of flexible structured suspension support mechanisms from a ceiling section of the vacuum chamber via a flange provided in an outer periphery section of the device.

29. The exposure system according to claim 28, wherein
the suspension support mechanism includes a vibration isolation pad fixed to the ceiling section, and a wire having one end connected to the vibration isolation pad and the other end connected to the support member of the charged particle beam irradiation device.

30. The exposure system according to one of claims 28 and 29, wherein
a ring-shaped projecting section is provided in an inner periphery section of the vacuum chamber, and
a ring-shaped connecting section that is freely expandable is provided in between the flange section and the ring-shaped projecting section, connecting both sections, and
the ring-shaped projecting section, the flange section, and the ring-shaped connecting section divide the first chamber and the second chamber.

31. The exposure system according to claim 30, wherein
at least a part of the ring-shaped connecting section is structured by a metal bellows.
